# EUROPEAN PATENT SPECIFICATION

(11) **EP 4 432 788 B1**
(45) Date of publication and mention of the grant of the patent: **10.12.2025**
(21) Application number: 24162127.5
(22) Date of filing: 07.03.2024
(51) Int. Cl.: H05K 1/02, H05K 1/18, H05K 3/42

(54) **ELECTRONIC SYSTEM**
ELEKTRONISCHES SYSTEM
SYSTÈME ÉLECTRONIQUE

(30) Priority: 15.03.2023 US 202363490297 P; 05.03.2024 US 202418595907
(43) Date of publication of application: 18.09.2024
(73) Proprietor: MEDIATEK INC., Hsinchu City 30078 (TW)
(72) Inventor: YI, Tso-Ju, 30078 Hsinchu City (TW); LEE, Chung-Fa, 30078 Hsinchu City (TW)
(74) Representative: Haseltine Lake Kempner LLP

(56) References cited:
- JP-A- 2000 101 245
- US-A1- 2014 174 795
- US-A1- 2017 171 957

## Description

### BACKGROUND OF THE DISCLOSURE

### Field of the Disclosure

The present disclosure relates to an electronic system and, in particular, to a printed circuit board (PCB) for developing ball grid array (BGA) integrated circuits (ICs) having an improved heat dissipation capacity.

### Description of the Related Art

In order to ensure the continued miniaturization and multi-functionality of electric products and communication devices, integrated circuits (ICs) need to be small in size, support multi-pin connection, operate at high speeds, and have high performance. This will put pressure on IC fabricators to develop ball grid array (BGA) integrated circuits. A BGA IC is typically joined to a mounting board by use of conductive balls (bumps) arranged in an array on its back as external terminals, instead of using a lead frame. Because the entire back surface of the BGA IC can be used for connection to the board, the number of input/output connections can be markedly increased. To support higher functionality, the number of pins has remarkably increased.

However, the increased number of input/output connections in a multi-functional BGA IC may lead to thermal electrical problems, such as heat dissipation, cross talk, signal propagation delay, and electromagnetic interference in RF circuits. These thermal electrical problems may affect the reliability and quality of the finished product.

Thus, a novel electronic system is desirable.

Reference may be made to the following documents:
JP 2000 101245 A, which relates to a multilayer resin wiring board and its manufacture;
US 2014/174795 A1, which relates to a printed wiring board, a printed circuit board, and a method for manufacturing a printed circuit board; and
US 2017/171957 A1, which relates to relates an electronic packaging that includes finned vias.

### BRIEF SUMMARY OF THE DISCLOSURE

The present invention is defined by the appended claims. An embodiment of the present disclosure provides an electronic system. The electronic system includes a base and a semiconductor device. The base having a device-attach region includes a build-up layer structure, a vertical interconnect structure and a first through via. The vertical interconnect structure is formed passing through the build-up layer structure and located in the device-attach region. The vertical interconnect structure includes at least one buried via and at least one blind via electrically coupled to the buried via. The first through via is formed passing through the build-up layer structure
and located in the device-attach region. The first through via is a straight through via.

An embodiment of the present disclosure provides an electronic system. The electronic system includes a base and a semiconductor device. The base having a device-attach region includes a build-up layer structure and a through via. The through via is formed passing through the build-up layer structure and located in the device-attach region. The first through via is a straight through via. The semiconductor device is mounted on the device-attach region.

### BRIEF DESCRIPTION OF THE DRAWINGS

The present disclosure can be more fully understood by reading the subsequent detailed description and examples with references made to the accompanying drawings, wherein:
FIG. 1 is a schematic top view of an electronic system in accordance with some embodiments of the disclosure;
FIG. 2 is a schematic cross-sectional view of the electronic system along the line A-A' of FIG. 1 in accordance with some embodiments of the disclosure;
FIG. 3 is a schematic cross-sectional view of the electronic system along the line B-B' of FIG. 1 in accordance with some embodiments of the disclosure;
FIG. 4A is a schematic top view of a base of an electronic system in accordance with some embodiments of the disclosure, showing the arrangement of a through via coupled to the ground plane and adjacent pads;
FIG. 4B is a schematic top view of the base of the electronic system of FIG. 4A in accordance with some embodiments of the disclosure, showing the arrangement of an opening of a solder mask layer of the base corresponding to the through via;
FIG. 5A is a schematic top view of a base of an electronic system in accordance with some embodiments of the disclosure, showing the arrangement of a through via coupled to the ground plane and adjacent pads;
FIG. 5B is a schematic top view of the base of the electronic system of FIG. 5A in accordance with some embodiments of the disclosure, showing the arrangement of an opening of a solder mask layer of the base corresponding to the through via;
FIG. 6A is a schematic top view of a base of an electronic system in accordance with some embodiments of the disclosure, showing the arrangement of a through via coupled to the ground plane and adjacent pads;
FIG. 6B is a schematic top view of the base of the electronic system of FIG. 6A in accordance with some embodiments of the disclosure, showing the arrangement of an opening of a solder mask layer of the base corresponding to the through via;
FIG. 7A is a schematic top view of a base of an electronic system in accordance with some embodiments of the disclosure, showing the arrangement of a through via coupled to the ground plane and adjacent pads;
FIG. 7B is a schematic top view of the base of the electronic system of FIG. 7A in accordance with some embodiments of the disclosure, showing the arrangement of an opening of a solder mask layer of the base corresponding to the through via;
FIG. 8A is a schematic top view of a base of an electronic system in accordance with some embodiments of the disclosure, showing the arrangement of a through via coupled to the ground plane and adjacent pads;
FIG. 8B is a schematic top view of the base of the electronic system of FIG. 8A in accordance with some embodiments of the disclosure, showing the arrangement of an opening of a solder mask layer of the base corresponding to the through via;
FIG. 9A is a schematic top view of a base of an electronic system in accordance with some embodiments of the disclosure, showing the arrangement of a through via coupled to the ground plane and adjacent pads;
FIG. 9B is a schematic top view of the base of the electronic system of FIG. 9A in accordance with some embodiments of the disclosure, showing the arrangement of an opening of a solder mask layer of the base corresponding to the through via;
FIG. 10A is a schematic top view of a base of an electronic system in accordance with some embodiments of the disclosure, showing the arrangement of a through via coupled to the ground plane and adjacent pads;
FIGS. 10B and 10C are schematic top views of the base of the electronic system of FIG. 10A in accordance with some embodiments of the disclosure, showing the arrangement of an opening of a solder mask layer of the base corresponding to the through via;
FIG. 11A is a schematic top view of a base of an electronic system in accordance with some embodiments of the disclosure, showing the arrangement of a through via coupled to the ground plane and adjacent pads;
FIG. 11B is a schematic top view of the base of the electronic system of FIG. 11A in accordance with some embodiments of the disclosure, showing the arrangement of an opening of a solder mask layer of the base corresponding to the through via;
FIG. 12A is a schematic top view of a base of an electronic system in accordance with some embodiments of the disclosure, showing the arrangement of a through via coupled to the ground plane and adjacent pads; and
FIG. 12B is a schematic top view of the base of the electronic system of FIG. 12A in accordance with some embodiments of the disclosure, showing the arrangement of an opening of a solder mask layer of the base corresponding to the through via.

### DETAILED DESCRIPTION OF THE DISCLOSURE

The following description is made for the purpose of illustrating the general principles of the disclosure and should not be taken in a limiting sense. The scope of the disclosure is best determined by reference to the appended claims.

As high performance ball grid array (BGA) integrated circuit (IC) demands larger currents at higher frequencies with lower power-supply voltages, power system design becomes increasingly challenging. In order to ensure the continued miniaturization and multi-functionality of electric products and communication devices, heat generated during operation of the BGA IC is required to quickly transmit to the mounting board (e.g., a printed circuit board (PCB)).

However, although existing printed circuit boards (PCBs) are generally adequate, they have not been satisfactory in every respect. For example, the conventional printed circuit board for BGA ICs merely have high density interconnects (HDIs) formed of buried vias and blind vias or merely have plating through holes (PTHs). However, the high density interconnects (HDIs) has poor heat dissipation efficiency. In another aspect, the bump structures of the BGA ICs directly on the plating through holes (PTHs) are removed and the PCB pads are not allowed to be formed on the terminals of the plating through holes (PTHs) according to the PCB design rule. This reduces current density of the BGA ICs. Therefore, further improvements to the printed circuit boards (PCBs) are required.

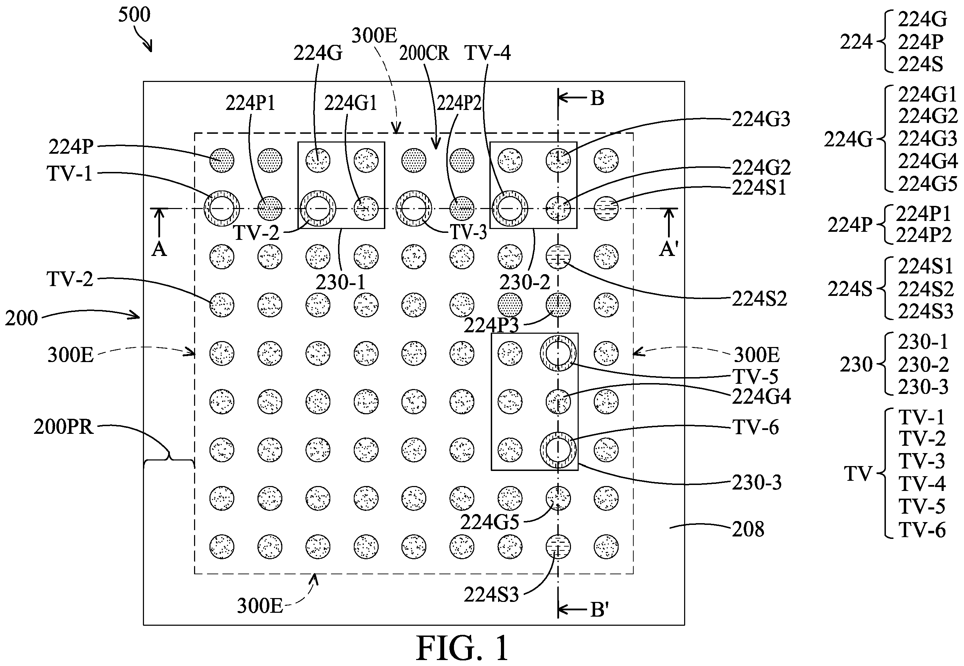

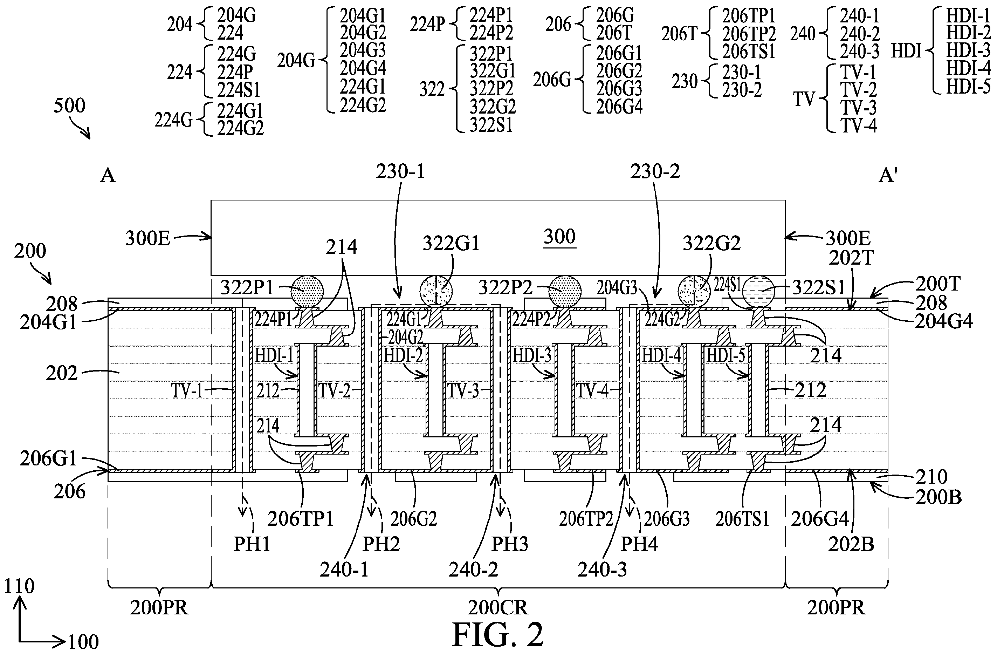

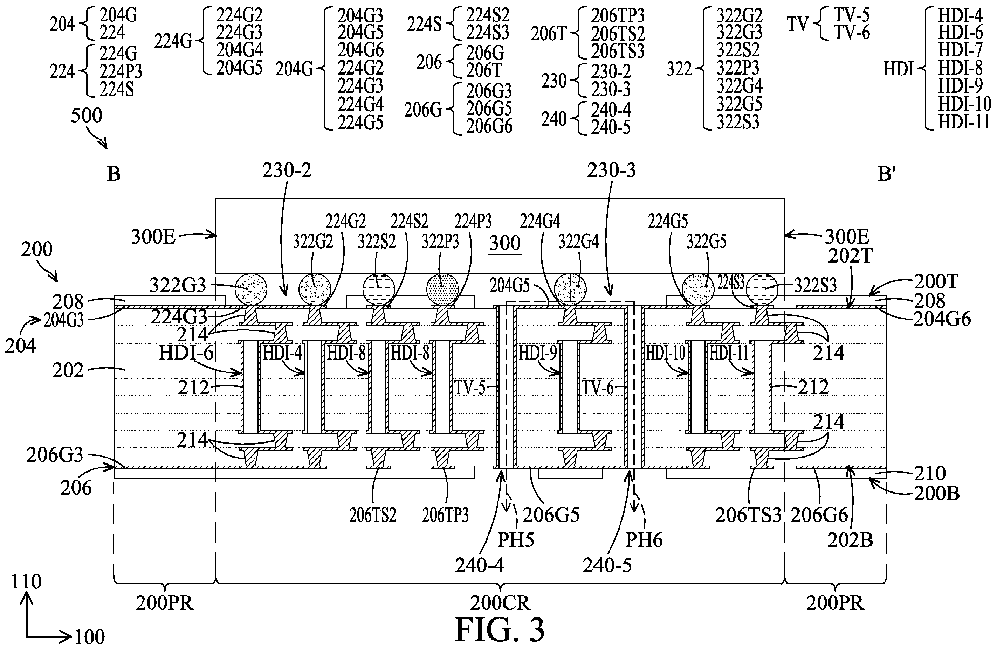

FIG. 1 is a schematic top view of an electronic system 500 in accordance with some embodiments of the disclosure. FIG. 2 is a schematic cross-sectional view of the electronic system 500 along the line A-A' of FIG. 1 in accordance with some embodiments of the disclosure. FIG. 3 is a schematic cross-sectional view of the electronic system 500 along the line B-B' of FIG. 1 in accordance with some embodiments of the disclosure. The electronic system 500 may include a base 200 and a semiconductor device 300 mounted on the base 200. In some embodiments, the electronic system 500 may include one semiconductor device or more than one vertically stacked semiconductor devices mounted on the base 200. For illustration of the relative position between the base 200 and the overlying semiconductor device 300, the semiconductor device 300 is hidden, and an edge 300E of the semiconductor device 300 is drawn in a dashed line in FIG. 1.

The semiconductor device 300 is disposed on a top surface 200T of the base 200. The semiconductor device 300 may include a plurality of conductive structures 322, the plurality of conductive structures 322 may include at least one grounded conductive structure, at least one power conductive structure and at least one signal grounded conductive structure. The semiconductor device 300 is mounted on the top surface 200T of the base 200 using the conductive structures 322 by a surface mount technology (SMT) process. In some embodiments, the semiconductor device 300 includes a semiconductor chip or a semiconductor package. For example, the semiconductor chip may include a micro control unit (MCU) chip, a microprocessor unit (MPU) chip, a power management integrated circuit (PMIC) chip, a global positioning system (GPS) chip, a central processing unit (CPU) chip, a graphics processing unit (GPU) chip, an input-output (IO) chip, a dynamic random access memory (DRAM) IP core, a static random-access memory (SRAM), a high bandwidth memory (HBM), a dynamic random access memory (DRAM) controller, a dynamic random access memory or any combination thereof. For example, the semiconductor package may include a fan-out package, a twodimensional (2D) package, a 2.5D package, a three-dimensional (3D) semiconductor package, or another suitable package. For example, the semiconductor package may include a system-on-chip (SOC) package, a memory package or a hybrid package (for packaging logic and memory dies).

The conductive structures 322 are disposed between the semiconductor device 300 and the base 200. The conductive structures 322 may be in contact with contact pads (not shown) of the semiconductor device 300 and corresponding pads (base pads) 224 of the base 200. The contact pads (not shown) of the semiconductor device 300 may include ground contact pads, power contact pads and signal contact pads. The pads 224 of the base 200 may include ground pads, power pads and signal pads and will be described later. Therefore, the semiconductor device 300 may be electrically coupled to the base 200 via the conductive structures 322. In some embodiments, the conductive structures 322 include a conductive ball structure such as a solder ball, copper-core solder ball, a conductive bump structure such as a copper bump or a solder bump structure, or a conductive pillar structure such as a copper pillar structure. For example, the conductive structures 322 may include microbumps, controlled collapse chip connection (C4) bumps, ball grid array (BGA) balls. the like, or a combination thereof. For example, the conductive structures 322 may be controlled collapse chip connection (C4) structures composed of conductive pillar structures and conductive bump structures.

As shown in FIGS. 1 to 3, for example, the base 200 may be a printed circuit board (PCB) including a high-density interconnect (HDI) circuit board having at least 4 layers. The base 200 may include a build-up layer structure 202, vertical interconnect structures HDI (including vertical interconnect structures HDI-1, HDI-2, HDI-3, HDI-4, HDI-5, HDI-6, HDI-7, HDI-8, HDI-9, HDI-10 and HDI-11), at least a through via TV (including through vias TV-1, TV-2, TV-3, TV-4, TV-5 and TV-6), a topmost conductive layer 204, a bottommost conductive layer 206 and solder mask layers 208, 210. In some embodiments, the build-up layer structure 202 may have a top surface 202T and a bottom surface 202B. The top surface 202T of the build-up layer structure 202 is close to the semiconductor device 300, while the bottom surface 202B of the build-up layer structure 202 is away from the semiconductor device 300. As shown in FIG. 1, the base 200 may have a device-attach region 200CR and a periphery region 200PR. The device-attach region 200CR may be defined by the edge 300E of the semiconductor device 300 in the top view as shown in FIG. 1. The device-attach region 200CR may be provided for the semiconductor device 300 mounted thereon by the conductive structures 322 (FIGS. 2 and 3). In addition, the periphery region 200PR may surround the device-attach region 200CR. In some embodiments, the build-up layer structure 202 may include a core substrate (not shown) and a plurality of alternating laminated conductive layers (not shown) and dielectric layers (not shown) stacked on opposite sides of the core substrate. In some embodiments, the build-up layer structure 202 may by fabricated without the core substrate and include a plurality of alternating laminated conductive layers (not shown) and dielectric layers (not shown). In some embodiments, the core substrate may be formed of polypropylene (PP), Pre-preg, FR-4 and/or other epoxy laminate material. In some embodiments, the conductive layer includes a conductive material, such as metals comprising copper, gold, silver, or other applicable metals. In some embodiments, the dielectric layer includes Pre-preg or other applicable dielectric materials. In some embodiments, the build-up layer structure 202 may include at least four conductive layers (not shown) and four dielectric layers (not shown).

As shown in FIGS. 2 and 3, the vertical interconnect structures HDI (including vertical interconnect structures HDI-1, HDI-2, HDI-3, HDI-4, HDI-5, HDI-6, HDI-7, HDI-8, HDI-9, HDI-10 and HDI-11) are formed in the build-up layer structure 202. In some embodiments, the vertical interconnect structures HDI may be formed passing through the build-up layer structure 202 and located in the device-attach region 200CR. In addition, the vertical interconnect structures HDI may be filled with epoxy resin. Each of the vertical interconnect structures HDI may include at least one buried via 212 and at least one blind via 214 electrically coupled to the buried via 212. In some embodiments, the buried via 212 and the blind via 214 of each of the vertical interconnect structures HDI may have a staggered arrangement along a direction 110 substantially perpendicular to the top surface 200T of the base 200. For example, the buried via 212 and the blind via 214 of each of the vertical interconnect structures HDI may extend along the direction 110 substantially perpendicular to the top surface 200T of the base 200 and discontinuously arranged. In some embodiments, the buried via 212 is formed embedded in the build-up layer structure 202 and electrically coupled to the internal conductive layers (not shown) of the build-up layer structure 202. In some embodiments, the blind via 214 is formed close to the top surface 202T and the bottom surface 202B of the build-up layer structure 202. Therefore, the topmost conductive layer 204 and the bottommost conductive layer 206 may be electrically coupled to the internal conductive layers (not shown) of the build-up layer structure 202 by the blind via 214. In some embodiments, the buried via 212 and the blind via 214 include a conductive material, such as metals comprising copper, gold, silver, or other applicable metals. In some embodiments, the buried via 212 and the blind via 214 may be formed by laser-drilling. However, it should be noted that the number and positions of the vertical interconnect structures HDI shown in FIGS. 2 and 3 are only an example and are not limited to the disclosed embodiments.

As shown in FIGS. 2 and 3, the through vias TV (including through vias TV-1, TV-2, TV-3, TV-4, TV-5 and TV-6) may be formed passing through the build-up layer structure 202 along the direction 110 substantially perpendicular to the top surface 200T of the base 200. In addition, the through vias TV may be located in the device-attach region 200CR. Each of the through vias TV may be formed by plating a thin conductive layer on an inner sidewall of a through hole (not shown) passing through the build-up layer structure 202. Furthermore, the through vias TV may be not filled with epoxy resin. The through vias TV may have a hollow pillar shape. Two terminals (not shown) of each of the through vias TV may be close to the top surface 202T and the bottom surface 202B of the build-up layer structure 202, respectively. In addition, the two terminals (not shown) of each of the through vias TV may be exposed from the top surface 202T and the bottom surface 202B of the build-up layer structure 202, respectively. However, it should be noted that the number and positions of the through vias TV shown in FIGS. 2 and 3 are only an example and are not limited to the disclosed embodiments. In some embodiments, each of the through vias TV is a straight through via. In other words, for each through via TV, the center lines of any two layers (or more layers) of the through via TV in the build-up layer structure 202 are aligned. In some embodiments, the diameters of the through via TV in any two layers (or more layers) of the build-up layer structure 202 are equal. In some embodiments, each of the vertical interconnect structures HDI is not a straight through via. In some embodiments, for each vertical interconnect structures HDI, the center line of one layer of the vertical interconnect structure HDI in the build-up layer structure 202 is offset with the center line of another layer (not aligned). For example, as shown in FIGS. 2 and 3, for each vertical interconnect structures HDI (including vertical interconnect structures HDI-1, HDI-2, HDI-3, HDI-4, HDI-5, HDI-6, HDI-7, HDI-8, HDI-9, HDI-10 and HDI-11), the center line of blind via 214 (one layer) in the build-up layer structure 202 is offset with the center line of a layer (another layer) of the buried via 212. In some embodiments, the diameters of the vertical interconnect structures HDI in any two layers (or more layers) of the build-up layer structure 202 are equal or unequal. In some embodiments, the base 200 has at least one through via TV disposed directly under the semiconductor device 300; and the at least one through via TV has lower thermal impedance and can provide a shorter path for heat dissipation. Therefore, the solution of this embodiment can help dissipate heat from the semiconductor device 300 and the base 200, thereby improving the heat dissipation efficiency of the electronic system 500. In some embodiments, each through via TV is in contact with a ground plane, to further improve the heat dissipation path and heat dissipation area by using the ground plane.

The conductive layer 204 is disposed on the top surface 202T of the build-up layer structure 202. The conductive layer 204 may cover the device-attach region 200CR and the periphery region 200PR. In the device-attach region 200CR, the conductive layer 204 may include conductive traces (not shown), ground planes 204G (including ground planes 204G1, 204G2, 204G3, 204G4, 204G5 and 204G6), signal pads 224S and power pads 224P. In addition, the ground planes 204G may extend from the device-attach region 200CR to the periphery region 200PR. In some embodiments, the ground planes 204G includes corresponding ground pads 224G (including ground pads 224G1, 224G2, 224G3, 224G4 and 224G5). In some embodiments, the conductive traces may include signal trace segments and power trace segments, which are used for the input/output (I/O) connections of the semiconductor device 300. In some embodiments, the conductive layer 204 includes a conductive material, such as metals comprising copper, gold, silver, or other applicable metals. For example, the conductive layer 204 may be a copper layer 204. However, it should be noted that the number and positions of the conductive traces (not shown), the ground planes 204G (including ground pads 224G), the signal pads 224S and the power pads 224P are only an example and are not limited to the disclosed embodiments.

As shown in FIGS. 2 and 3, in some embodiments, the ground planes 204G in the device-attach region 200CR may be in contact with the corresponding through vias TV, the corresponding conductive structures 322 of the semiconductor device 300 and the corresponding vertical interconnect structures HDI. In some embodiments, the ground planes 204G in the device-attach region 200CR may be coupled to and in contact with the corresponding through vias TV only. In some embodiments, the ground planes 204G in the device-attach region 200CR may be merely coupled to and in contact with the conductive structure 322 of the semiconductor device 300 and the corresponding vertical interconnect structures HDI. In addition, the ground pads 224G may be coupled to the grounded conductive structures (e.g., conductive structures 322G1, 322G2, 322G3, 322G4 and 322G5) of the conductive structures 322. For example, the grounded conductive structures (e.g., conductive structures 322G1, 322G2, 322G3, 322G4 and 322G5) may include ground balls electrically coupled to the ground contact pads of the semiconductor device 300. Furthermore, the grounded conductive structures (e.g., the ground balls 322G1, 322G2, 322G3, 322G4 and 322G5) may be disposed directly on and in contact with the corresponding ground pads 224G. Moreover, the ground pads 224G may be disposed directly on and in contact with the vertical interconnect structures HDI corresponding to the grounded conductive structures (e.g., conductive structures 322G1, 322G2, 322G3, 322G4 and 322G5) . The grounded conductive structures (e.g., conductive structures 322G1, 322G2, 322G3, 322G4 and 322G5) and the corresponding vertical interconnect structures HDI are disposed on opposite surfaces of the ground pads 224G.

As shown in FIGS, 2 and 3, in some embodiments, the ground planes 204G may be adjacent to and in contact with terminals (not shown) of the through vias TV close to the top surface 202T of the build-up layer structure 202. In addition, the ground planes 204G does not cover the terminals of the through vias TV close to the top surface 202T of the build-up layer structure 202. Each of the ground pads 224G may be offset from the through vias TV coupled to the same ground plane 204G along a direction 100 (the direction 100 substantially parallel to the top surface 200T of the base 200). In other words, the vertical interconnect structure HDI and the grounded conductive structure (e.g., conductive structures 322G1, 322G2, 322G3, 322G4 and 322G5) are in contact with a first portion (e.g., the ground pad 224G) of the ground plane 204G. In some embodiments, each through via TV does not have a corresponding pad (such as a ground pad) and conductive structure (such as a conductive ball structure), while each vertical interconnect structure HDI has a corresponding pad (such as the ground pad 224G, the power pad 224P or the signal pad 224S) and conductive structure (such as the grounded conductive structure 322G1, the conductive structure 322P1, or the conductive structure 322S1). In addition, the through via TV is in contact with the second portion (e.g., a portion of the ground plane 204G close to the terminal of the through via TV close to the top surface 202T of the build-up layer structure 202) of the ground plane 204G. In some embodiments, the through vias TV in contact with different ground planes 204G may be electrically coupled together by the internal conductive layers of the build-up layer structure 202. In some embodiments, the ground planes 204G in the device-attach region 200CR and the periphery region 200PR may be coupled to each other to collectively form a ground net (not shown) of the base 200. However, it should be noted that the number of the through vias TV in contact with the same ground plane 204G are only an example and are not limited to the disclosed embodiments.

As shown in FIG, 2, for example, the ground plane 204G1 may cover both the device-attach region 200CR and the periphery region 200PR. The ground plane 204G1 may be in contact with the through via TV-1 only. The ground plane 204G1 may be adjacent to and in contact with a terminal (not shown) of the through via TV-1 close to the top surface 202T of the build-up layer structure 202. In addition, the ground plane 204G1 does not cover the terminal of the through via TV-1 close to the top surface 202T of the build-up layer structure 202. The ground plane 204G1 may be not coupled to and in contact with any grounded conductive structure (e.g., conductive structures 322G1, 322G2, 322G3, 322G4 and 322G5) of the semiconductor device 300 and the vertical interconnect structure HDI.

As shown in FIG, 2, for example, the ground pad 224G1 may be in contact with the through vias TV-2 and TV-3, the conductive structure 322G1 and the vertical interconnect structure HDI-2. The ground pad 224G1 may be coupled to the corresponding conductive structure 322G1 (e.g., the ground balls). In addition, the conductive structure 322G1 may be disposed directly on and in contact with the ground pad 224G1. Furthermore, the ground pad 224G1 is disposed directly on and in contact with the vertical interconnect structure HDI-2 corresponding to the conductive structure 322G1. The ground plane 204G2 may be adjacent to and in contact with terminals (not shown) of the through vias TV-2 and TV-3 close to the top surface 202T of the build-up layer structure 202. In addition, the ground plane 204G2 does not cover the terminals of the through vias TV-2 and TV-3 close to the top surface 202T of the build-up layer structure 202. The ground pad 224G1 may be offset from the through vias TV-2 and TV-3 coupled to the same ground plane 204G2 along the direction 100 substantially parallel to the top surface 200T of the base 200. In other words, the vertical interconnect structure HDI-2 and the grounded conductive structure 322G1 are in contact with a first portion (e.g., the ground pad 224G1) of the ground plane 204G2. The through vias TV-2 and TV-3 are in contact with a second portion (e.g., a portion of the ground plane 204G2 close to the terminals of the through vias TV-2 and TV-3 close to the top surface 202T of the build-up layer structure 202) of the ground plane 204G2.

As shown in FIGS, 2 and 3, for example, the ground plane 204G3 may extend to cover both the device-attach region 200CR and the periphery region 200PR. For example, the ground pads 224G2 and 224G3 may be in contact with the through via TV-4 and the corresponding vertical interconnect structures HDI-4 and HDI-6. The ground pads 224G2 and 224G3 may be coupled to the corresponding conductive structures 322G2 and 322G3 (e.g., the ground balls). The conductive structure 322G3 may be disposed directly on and in contact with the ground pad 224G3. The conductive structure 322G2 may be disposed directly on and in contact with the ground pad 224G2. In addition, the conductive structure 322G3 may be disposed directly on and in contact with the ground pad 224G3. Furthermore, the ground pad 224G2 is disposed directly on and in contact with the vertical interconnect structure HDI-4 corresponding to the conductive structure 322G2. Moreover, the ground pad 224G3 is disposed directly on and in contact with the vertical interconnect structure HDI-6 corresponding to the conductive structure 322G3. The ground plane 204G3 may be adjacent to and in contact with a terminal (not shown) of the through via TV-4 close to the top surface 202T of the build-up layer structure 202. In addition, the ground plane 204G3 does not cover the terminal of the through via TV-4 close to the top surface 202T of the build-up layer structure 202. The ground pads 224G2 and 224G3 may be offset from the through via TV-4 coupled to the same ground plane 204G3 along the direction 100 substantially parallel to the top surface 200T of the base 200. In other words, the vertical interconnect structures HDI-4 and HDI-6 and the grounded conductive structures 322G2 and 322G3 are in contact with the ground pads 224G2 and 224G3 of the ground plane 204G3. The through via TV-4 is in contact with a portion of the ground plane 204G3 which is close to the terminals of the through via TV-4 close to the top surface 202T of the build-up layer structure 202. The portion of the ground plane 204G3 is different from the ground pads 224G2 and 224G3 of the ground plane 204G3.

As shown in FIG, 3, for example, the ground plane 204G5 including the ground pad 224G4 and 224G5, the ground pad 224G4 may be in contact with the through vias TV-5 and TV-6, the conductive structure 322G4 and the vertical interconnect structures HDI-9 and HDI-10, and the ground pad 224G5 may be in contact with the through via TV-6, the conductive structure322G5 and the vertical interconnect structure HDI-10. The ground pads 224G4 and 224G5 may be coupled to the corresponding conductive structures 322G4 and 322G5 (e.g., the ground balls). The conductive structure 322G4 may be disposed directly on and in contact with the ground pad 224G4. In addition, the conductive structure 322G5 may be disposed directly on and in contact with the ground pad 224G5. Furthermore, the ground pad 224G4 is disposed directly on and in contact with the vertical interconnect structure HDI-9 corresponding to the conductive structure 322G4. Moreover, the ground pad 224G5 is disposed directly on and in contact with the vertical interconnect structure HDI-10 corresponding to the conductive structure 322G5. The ground plane 204G5 may be adjacent to and in contact with terminals (not shown) of the through vias TV-5 and TV-6 close to the top surface 202T of the build-up layer structure 202. In addition, the ground plane 204G5 does not cover the terminals of the through vias TV-5 and TV-6 close to the top surface 202T of the build-up layer structure 202. The ground pads 224G4 and 224G5 may be offset from the through vias TV-5 and TV-6 coupled to the same ground plane 204G5 along the direction 100 substantially parallel to the top surface 200T of the base 200. In other words, the vertical interconnect structures HDI-9 and HDI-10 and the grounded conductive structures 322G4 and 322G5 are in contact with the ground pads 224G4 and 224G5 of the ground plane 204G5. The through vias TV-5 and TV-6 are in contact with portions of the ground plane 204G5 which are close to the terminals of the through vias TV-5 and TV-6 close to the top surface 202T of the build-up layer structure 202. The portions of the ground plane 204G5 are different from the ground pads 224G4 and 224G5 of the ground plane 204G5.

As shown in FIGS. 2 and 3, for example, the through via TV1 in contact with the ground plane 204G1, the through vias TV-2 and TV-3 in contact with the same ground plane 204G2, the through via TV4 in contact with the ground plane 204G3, and the through vias TV-5 and TV-6 in contact with the same ground plane 204G5 may be electrically coupled together by the internal conductive layers (not shown) of the build-up layer structure 202. In some embodiments, each pad (such as the ground pad, power pad or signal pad) corresponding to the vertical interconnect structure HDI (such as the vertical interconnect structure HDI-1, HDI-2, HDI-3, HDI-4, HDI-5, HDI-6, HDI-7, HDI-8, HDI-9, HDI-10 or HDI-11) is in contact with the corresponding vertical interconnect structure HDI and is also in contact with the corresponding conductive structure 322. In some embodiments, each through via TV has no corresponding pad or conductive structure. In some embodiments, the pads (such as the ground pads, power pads and signal pads) are only disposed on the corresponding vertical interconnect structures HDI (such as the vertical interconnect structure HDI-1, HDI-2, HDI-3, HDI-4, HDI-5, HDI-6, HDI-7, HDI-8, HDI-9, HDI-10 and HDI-11), and there is no pad directly above each through-hole TV. In some embodiments, the pads (such as the ground pads, power pads and signal pads) are only disposed on the corresponding vertical interconnect structures HDI (such as the vertical interconnect structure HDI-1, HDI-2, HDI-3, HDI-4, HDI-5, HDI-6, HDI-7, HDI-8, HDI-9, HDI-10 and HDI-11), and there is no pad directly above each through via TV. In some embodiments, conductive structure 322 are only disposed above the corresponding vertical interconnect structures HDI (such as the vertical interconnect structure HDI-1, HDI-2, HDI-3, HDI-4, HDI-5, HDI-6, HDI-7, HDI-8, HDI-9, HDI-10 and HDI-11), and there is no conductive structure 322 directly above each through via TV.

In some embodiments, the ground planes 204G1, 204G2, 204G3 and 204G5 in the device-attach region 200CR and the periphery region 200PR and the ground planes 204G4 and 204G6 in the periphery region 200PR may be coupled to each other to collectively form a ground net (not shown) of the base 200.

As shown in FIGS, 2 and 3, for example, the power pads 224P (including power pads 224P1, 224P2 and 224P3) may be coupled to and in contact with different terminals of the power trace segments. In addition, the power pads 224P may be coupled to the corresponding conductive structures 322 utilized to transmit power. For example, the conductive structures 322 utilized to transmit power may include power balls electrically coupled to the power contact pads of the semiconductor device 300. Furthermore, the conductive structures 322 (e.g., the power balls) may be disposed directly on and in contact with the corresponding power pads 224P. Moreover, the power pads 224P may be disposed directly on and in contact with the vertical interconnect structures HDI corresponding to the conductive structures 322 utilized to transmit power. The conductive structures 322 utilized to transmit power and the corresponding vertical interconnect structures HDI are disposed on opposite surfaces of the power pads 224P. The power pads 224P, the conductive structures 322 utilized to transmit power and the corresponding vertical interconnect structures HDI are not in contact with the through vias TV.

As shown in FIG. 2, for example, the power pad 224P1 may be coupled to and in contact with terminals of the power trace segments (not shown). In addition, the power pad 224P1 may be coupled to the corresponding conductive structure 322P1 (e.g., the power ball). Furthermore, the conductive structure 322P1 (e.g., the power ball) may be disposed directly on and in contact with the corresponding power pad 224P1. Moreover, the power pad 224P1 may be disposed directly on and in contact with the vertical interconnect structure HDI-1 corresponding to the conductive structure 322P1. The conductive structure 322P1 (power conductive structure) and the corresponding vertical interconnect structure HDI-1 are disposed on opposite surfaces of the power pad 224P1. The power pad 224P1, the conductive structure 322P1 and the corresponding vertical interconnect structure HDI-1 are not in contact with the through vias TV.

As shown in FIG, 2, for example, the power pad 224P2 may be configured similarly to the power pad 224P1. Furthermore, the power pad 224P2 may be disposed between the vertical interconnect structure HDI-3 and the corresponding conductive structure 322P2.

As shown in FIG, 3, for example, the power pad 224P3 may be configured similarly to the power pad 224P1. Furthermore, the power pad 224P3 may be disposed between the vertical interconnect structure HDI-8 and the corresponding conductive structure 322P3.

As shown in FIGS. 2 and 3, for example, the signal pads 224S (including signal pads 224S1, 224S2 and 224S3) may be coupled to and in contact with different terminals of the signal trace segments. In addition, the signal pads 224S may be coupled to the corresponding conductive structures 322 utilized to transmit signals. For example, the conductive structures 322 utilized to transmit signals may include signal balls electrically coupled to the signal contact pads of the semiconductor device 300. Furthermore, the conductive structures 322 (e.g., the signal balls) utilized to transmit signals may be disposed directly on and in contact with the corresponding signal pads 224S. Moreover, the signal pads 224S may be disposed directly on and in contact with the vertical interconnect structures HDI corresponding to the conductive structures 322 utilized to transmit signals. The conductive structures 322 utilized to transmit signals and the corresponding vertical interconnect structures HDI are disposed on opposite surfaces of the signal pads 224S. The signal pads 224S, the conductive structures 322 utilized to transmit signals and the corresponding vertical interconnect structures HDI are not in contact with the through vias TV.

As shown in FIG. 2, for example, the signal pad 224S1 may be coupled to and in contact with different terminals of the signal trace segments (not shown). In addition, the signal pad 224S1 may be coupled to the corresponding conductive structure 322S1 (e.g., the signal ball). Furthermore, the conductive structure 322S1 (e.g., the signal ball) may be disposed directly on and in contact with the corresponding signal pad 224S1. Moreover, the signal pad 224S1 may be disposed directly on and in contact with the vertical interconnect structure HDI-5 corresponding to the conductive structure 322S1. The conductive structure 322S1 (signal conductive structure) and the corresponding vertical interconnect structure HDI-5 are disposed on opposite surfaces of the signal pad 224S1. The signal pad 224S1, the conductive structure 322S1 and the corresponding vertical interconnect structure HDI-5 are not in contact with the through vias TV.

As shown in FIG. 3, for example, the signal pad 224S2 may be configured similarly to the signal pad 224S1. Furthermore, the signal pad 224S2 may be disposed between the vertical interconnect structure HDI-7 and the corresponding conductive structure 322S2.

As shown in FIG. 3, for example, the signal pad 224S3 may be configured similarly to the signal pad 224S1. Furthermore, the signal pad 224S3 may be disposed between the vertical interconnect structure HDI-11 and the corresponding conductive structure 322S3.

The bottommost conductive layer 206 may be formed on the bottom surface 202B of the build-up layer structure 202. The bottommost conductive layer 206 may cover the device-attach region 200CR and the periphery region 200PR. In the device-attach region 200CR, the bottommost conductive layer 206 may include conductive traces 206T (including conductive traces 206TP1, 206TP2, 206TP3, 206TS1, 206TS2 and 206TS3) and ground planes 206G (including ground planes 206G1, 206G2, 206G3, 206G4, 206G5 and 206G6). In addition, the ground planes 206G may extend from the device-attach region 200CR to the periphery region 200PR. In some embodiments, the topmost conductive layer 204 and the bottommost conductive layer 206 may include the same or similar materials and structures. For example, the bottommost conductive layer 206 may be a copper layer 206. However, it should be noted that the number and positions of the conductive traces 206T and the ground planes 206G are only an example and are not limited to the disclosed embodiments.

As shown in FIGS. 2 and 3, in some embodiments, the ground planes 206G in the device-attach region 200CR may be in contact with the corresponding through vias TV and the corresponding vertical interconnect structures HDI. In some embodiments, the ground planes 206G in the device-attach region 200CR may be coupled to and in contact with the corresponding through vias TV only. In some embodiments, the ground planes 206G in the device-attach region 200CR may be merely coupled to and in contact with the corresponding vertical interconnect structures HDI. In addition, the ground planes 206G may be disposed below and in contact with the vertical interconnect structures HDI and opposite the ground planes 204G. When the ground planes 206G is in contact with both the through via TV and the vertical interconnect structure HDI, the through via TV and the vertical interconnect structure HDI are in contact with different portions of the ground plane 206G.

As shown in FIGS 2 and 3, in some embodiments, the ground planes 206G may be adjacent to and in contact with terminals (not shown) of the through vias TV close to the bottom surface 202B of the build-up layer structure 202. In addition, the ground planes 206G does not cover the terminals of the through vias TV close to the bottom surface 202B of the build-up layer structure 202. In some embodiments, the ground planes 206G in the device-attach region 200CR and the periphery region 200PR may be coupled to each other to collectively form a ground net (not shown) of the base 200.

As shown in FIG. 2, for example, the ground plane 206G1 may cover both the device-attach region 200CR and the periphery region 200PR. The ground plane 206G1 may be coupled to and in contact with the through via TV-1 only. The ground plane 206G1 may be adjacent to and in contact with a terminal (not shown) of the through via TV-1 close to the bottom surface 202B of the build-up layer structure 202. In addition, the ground plane 206G1 does not cover the terminal of the through via TV-1 close to the bottom surface 202B of the build-up layer structure 202.

As shown in FIG, 2, for example, the ground plane 206G2 in the device-attach region 200CR may be in contact with the corresponding through vias TV-2, TV-3 and the corresponding vertical interconnect structure HDI-2. In addition, the ground plane 206G2 may be disposed below and in contact with the vertical interconnect structure HDI-2 and opposite the ground planes 204G2. The ground plane 206G2 may be adjacent to and in contact with terminals (not shown) of the through vias TV-2, TV-3 close to the bottom surface 202B of the build-up layer structure 202. In addition, the ground plane 206G2 does not cover the terminals of the through vias TV-2, TV-3 close to the bottom surface 202B of the build-up layer structure 202. The through via TV-2 and the vertical interconnect structure HDI-2 are in contact with different portions of the ground plane 206G2. The through via TV-3 and the vertical interconnect structure HDI-2 are in contact with different portions of the ground plane 206G2.

As shown in FIGS, 2 and 3, for example, the ground planes 206G3 may cover both the device-attach region 200CR and the periphery region 200PR. For example, the ground plane 206G3 in the device-attach region 200CR may be in contact with the corresponding through via TV-4 and the corresponding vertical interconnect structures HDI-4 and HDI-6. In addition, the ground plane 206G3 may be disposed below and in contact with the vertical interconnect structures HDI-4 and HDI-6 and opposite the ground planes 204G3. The ground plane 206G2 may be adjacent to and in contact with a terminal (not shown) of the through via TV-4 close to the bottom surface 202B of the build-up layer structure 202. In addition, the ground plane 206G3 does not cover the terminal of the through via TV-4 close to the bottom surface 202B of the build-up layer structure 202. The through via TV-4 and the vertical interconnect structure HDI-4 are in contact with different portions of the ground plane 206G3. The through via TV-4 and the vertical interconnect structure HDI-6 are in contact with different portions of the ground plane 206G3.

As shown in FIG, 3, for example, the ground plane 206G5 in the device-attach region 200CR may be in contact with the corresponding through vias TV-5, TV-6 and the corresponding vertical interconnect structures HDI-9, HDI-10. In addition, the ground plane 206G5 may be disposed below and in contact with the vertical interconnect structures HDI-9, HDI-10 and opposite the ground planes 204G3. The ground plane 206G5 may be adjacent to and in contact with terminals (not shown) of the through vias TV-5, TV-6 close to the bottom surface 202B of the build-up layer structure 202. In addition, the ground plane 206G5 does not cover the terminals of the through vias TV-5, TV-6 close to the bottom surface 202B of the build-up layer structure 202. The through vias TV-5, TV-6 and the vertical interconnect structures HDI-9, HDI-10 are in contact with different portions of the ground plane 206G5.

In some embodiments, the ground planes 206G1, 206G2, 206G3 and 206G5 may be in the device-attach region 200CR and the periphery region 200PR, and the ground planes 206G4 and 206G6 may be in the periphery region 200PR only. The ground planes 206G1, 206G2, 206G3 and 206G5 and the ground planes 206G4 and 206G6 may be electrically coupled to each other to collectively form a ground net (not shown) of the base 200. In addition, the ground planes 204G1 to 204G6 and 206G1 to 206G6 in the device-attach region 200CR and the periphery region 200PR may be coupled to each other to collectively form a ground net (not shown) of the base 200.

As shown in FIGS. 2 and 3, in some embodiments, the conductive traces 206T (including conductive traces 206TP1, 206TP2, 206TP3, 206TS1, 206TS2 and 206TS3) may be disposed below and in contact with the vertical interconnect structures HDI and opposite the power pads 224P or the signal pads 224S.

As shown in FIG, 2, for example, the conductive trace 206TP1 may be disposed below and in contact with the vertical interconnect structure HDI-1 and opposite the power pad 224P1. The conductive trace 206TP2 may be disposed below and in contact with the vertical interconnect structure HDI-3 and opposite the power pad 224P2. The conductive trace 206TS1 may be disposed below and in contact with the vertical interconnect structure HDI-4 and opposite the signal pad 224S1.

As shown in FIG, 3, for example, the conductive trace 206TS2 may be disposed below and in contact with the vertical interconnect structure HDI-7 and opposite the signal pad 224S2. The conductive trace 206TP3 may be disposed below and in contact with the vertical interconnect structure HDI-8 and opposite the power pad 224P3. The conductive trace 206TS3 may be disposed below and in contact with the vertical interconnect structure HDI-11 and opposite the signal pad 224S3.

As shown in FIGS. 2 and 3, in some embodiments, the through vias TV directly passing through the build-up layer structure 202 may provide shorter heat dissipation paths for the semiconductor device 300 than the vertical interconnect structures HDI. The through vias TV-1, TV-2, TV-3, TV-4, TV-5 and TV-6, the ground planes 204G and 206G in contact with the terminals of the through vias TV-1, TV-2, TV-3, TV-4, TV-5 and TV-6, and the corresponding grounded conductive structures 322 may collectively form heat dissipation paths PH-1, PH-2, PH-3, PH-4, PH-5 and PH-6 from the top of the base 200 through the through vias TV and to the bottom of the base 200. The heat dissipation paths PH-1, PH-2, PH-3, PH-4, PH-5 and PH-6 may substantially extend along the direction 110. Heat generated from the semiconductor device 300 may be quickly transmitted to the ambient air along the heat dissipation paths PH-1, PH-2, PH-3, PH-4, PH-5 and PH-6. In addition, the internal conductive layers of the build-up layer structure 202 coupled to the through vias TV-1, TV-2, TV-3, TV-4, TV-5 and TV-6 may form additional heat dissipation paths (not shown) from the top of the base 200 through the through vias TV and to the sides of the base 200. The additional heat dissipation paths (not shown) may substantially extend along the direction 100. Heat generated from the semiconductor device 300 may be quickly transmitted to the ambient air along the additional heat dissipation paths. However, the number and positions of the heat dissipation paths are not limited to the disclosed embodiments.

The solder mask layer 208 is disposed on the top surface 202T of the build-up layer structure 202. The solder mask layer 208 may be directly disposed on the conductive layer 204. In some embodiments, the solder mask layer 208 may cover the conductive traces of the topmost conductive layer 204. In addition, the solder mask layer 208 may have openings (not shown) to expose the corresponding power pads 224P and the corresponding signal pads 224S. In some embodiments, the solder mask layer 208 may include an epoxy resin. In some embodiments, the solder mask layer 208 may cover the ground planes 204G in the periphery region 200PR. The solder mask layer 208 may cover a portion of the ground planes 204G in the device-attach region 200CR and have openings (not shown) to expose the corresponding ground pads 224G. In some embodiments, a top surface 200T of the solder mask layer 208 close to the semiconductor device 300 may serve as the top surface 200T (which also serves as a chip-attach surface) of the base 200.

The solder mask layer 208 has at least one opening 230 (including openings 230-1, 230-2 and 230-3) to expose at least one corresponding through via TV to improve the heat dissipation capacity of the base 200. In some embodiments, the ground pad 224G and a portion of the ground plane 204G adjacent to the ground pad 224G may be optionally exposed from the opening 230 to further improve the heat dissipation capacity of the electronic system 500. In some embodiments, at least a portion of the ground plane 204G adjacent to the through via TV may be optionally exposed from the opening 230 to further improve the heat dissipation capacity of the electronic system 500. In some embodiments, the through via TV may be optionally covered by the solder mask layer 208.

As shown in FIGS, 2 and 3, for example, the solder mask layer 208 may cover the ground planes 204G1, 204G4, 204G6 and optionally cover the corresponding through via TV-1. In this embodiment, the ground plane 204G1 in contact with the through via TV-1 may be optionally covered by the solder mask layer 208.

As shown in FIG, 2, for example, the solder mask layer 208 may optionally have the opening 230-1 to expose the corresponding through vias TV-2, TV-3, the corresponding ground pad 224G1, and the ground plane 204G2 adjacent to the through vias TV-2, TV-3 and the ground pad 224G1. In this embodiment, the ground plane 204G2 in contact with the through vias TV-2 and TV-3 may have an increased exposed area exposed from the opening 230-1, the heat dissipation capacity of the electronic system 500 may be further improved.

As shown in FIGS, 2 and 3, for example, the solder mask layer 208 may cover a portion of the ground plane 204G3 close to the corresponding ground pad 224G2. In addition, the solder mask layer 208 may optionally have the opening 230-2 to expose the corresponding through via TV-4, the corresponding ground pads 224G2, 224G3, and the ground plane 204G3 adjacent to the through via TV-4 and the ground pads 224G2, 224G3. In this embodiment, the ground plane 204G3 in contact with the through via TV-4 may have an increased exposed area exposed from the opening 230-2, the heat dissipation capacity of the electronic system 500 may be further improved.

As shown in FIG, 3, for example, the solder mask layer 208 may cover a portion of the ground plane 204G5 adjacent to the corresponding ground pad 224G5. In addition, the solder mask layer 208 may have an opening to expose the corresponding ground pad 224G5. For example, the solder mask layer 208 may optionally have the opening 230-3 to expose the corresponding through vias TV-5, TV-6, the corresponding ground pad 224G4, and the ground plane 204G5 adjacent to the through vias TV-5, TV-6 and the ground pad 224G4. In this embodiment, the ground plane 204G5 in contact with the through vias TV-5, TV-6 may have an increased exposed area exposed from the opening 230-3, the heat dissipation capacity of the electronic system 500 may be further improved.

The solder mask layer 210 may be disposed on the bottom surface 202B of the build-up layer structure 202. The solder mask layer 210 may be directly disposed on the bottommost conductive layer 206. In some embodiments, the solder mask layers 208 and 210 may include the same or similar materials. In some embodiments, the solder mask layer 210 may cover the conductive traces 206T of the bottommost conductive layer 206. In addition, the solder mask layer 210 may have openings to expose the conductive traces 206T of the bottommost conductive layer 206. In some embodiments, a bottom surface 200B of the solder mask layer 210 located away from the semiconductor device 300 may serve as a bottom surface 200B of the base 200.

In some embodiments, the solder mask layer 210 may optionally have at least one opening 240 (including openings 240-1, 240-2, 240-3, 240-4 and 240-5) to expose at least one corresponding through via TV to improve the heat dissipation capacity of the electronic system 500. In some embodiments, a portion of the ground plane 206G adjacent to the through via TV may be optionally exposed from the opening 240 to further improve the heat dissipation capacity of the electronic system 500.

In some embodiments, the opening 240 of the solder mask layer 210 may be aligned with the opening 230 of the solder mask layer 208 is along the direction 110 substantially perpendicular to the top surface 200T of the base 200 to further improve the heat dissipation capacity of the electronic system 500. In some embodiments, the opening 240 of the solder mask layer 210 and the opening 230 of the solder mask layer 208 may expose the two terminals of the corresponding through via TV to further improve the heat dissipation capacity of the electronic system 500. In some embodiments, the opening 240 of the solder mask layer 210 and the opening 230 of the solder mask layer 208 may be in many-to-one or one-to-one relationship.

In some embodiments, the through via TV may be optionally covered by the solder mask layer 210 and/or the solder mask layer 208. For example, one terminal of the corresponding through via TV may be optionally covered by the solder mask layer 208, and another one terminal of the corresponding through via TV may be optionally exposed from the opening 240 of the solder mask layer 210. For example, one terminal of the corresponding through via TV may be optionally covered by the solder mask layer 210, and another one terminal of the corresponding through via TV may be optionally exposed from the opening 230 of the solder mask layer 208. For example, two terminals of the corresponding through via TV may be optionally covered by the solder mask layer 210 and the solder mask layer 208.

As shown in FIG, 2, for example, the solder mask layer 210 may optionally have the openings 240-1, 240-2 to expose the corresponding through vias TV-2, TV-3 to improve the heat dissipation capacity of the electronic system 500. In some embodiments, a portion of the ground plane 206G2 adjacent to the through vias TV-2, TV-3 may be optionally exposed from the openings 240-1, 240-2 to further improve the heat dissipation capacity of the electronic system 500. In some embodiments, the opening 240-1 of the solder mask layer 210 may be aligned with the opening 230-1 of the solder mask layer 208 is along the direction 110 to further improve the heat dissipation capacity. In some embodiments, the opening 240-2 of the solder mask layer 210 may be aligned with the opening 230-1 of the solder mask layer 208 is along the direction 110 to further improve the heat dissipation capacity of the electronic system 500. In some embodiments, the opening 240-1 of the solder mask layer 210 and the opening 230-1 of the solder mask layer 208 may expose the two terminals of the corresponding through via TV-2 to further improve the heat dissipation capacity of the electronic system 500. In some embodiments, the opening 240-2 of the solder mask layer 210 and the opening 230-1 of the solder mask layer 208 may expose the two terminals of the corresponding through via TV-2 to further improve the heat dissipation capacity of the electronic system 500. In some embodiments, the openings 240-1, 240-2 of the solder mask layer 210 and the opening 230-1 of the solder mask layer 208 may be in many-to-one relationship.

As shown in FIG, 2, for example, the solder mask layer 210 may optionally have the opening 240-3 to expose at least one corresponding through via TV-4 to improve the heat dissipation capacity of the electronic system 500. In some embodiments, a portion of the ground plane 206G3 adjacent to the through via TV-4 may be optionally exposed from the opening 240-3 to further improve the heat dissipation capacity of the electronic system 500. In some embodiments, the opening 240-3 of the solder mask layer 210 may be aligned with the opening 230-2 of the solder mask layer 208 is along the direction 110 to further improve the heat dissipation capacity of the electronic system 500. In some embodiments, the opening 240-3 of the solder mask layer 210 and the opening 230-2 of the solder mask layer 208 may expose the two terminals of the corresponding through via TV-4 to further improve the heat dissipation capacity of the electronic system 500. In some embodiments, the opening 240-3 of the solder mask layer 210 and the opening 230-2 of the solder mask layer 208 may be in one-to-one relationship.

As shown in FIG, 3, for example, the solder mask layer 210 may optionally have the openings 240-4, 240-5 to expose at least one corresponding through vias TV-5, TV-6 to improve the heat dissipation capacity of the electronic system 500. In some embodiments, portions of the ground plane 206G5 adjacent to the through vias TV-5, TV-6 may be optionally exposed from the openings 240-4, 240-5 to further improve the heat dissipation capacity of the electronic system 500. In some embodiments, the opening 240-4 of the solder mask layer 210 may be aligned with the opening 230-3 of the solder mask layer 208 is along the direction 110 to further improve the heat dissipation capacity of the electronic system 500. In some embodiments, the opening 240-5 of the solder mask layer 210 may be aligned with the opening 230-3 of the solder mask layer 208 is along the direction 110 to further improve the heat dissipation capacity of the electronic system 500. In some embodiments, the opening 240-4 of the solder mask layer 210 and the opening 230-3 of the solder mask layer 208 may expose the two terminals of the corresponding through via TV-5 to further improve the heat dissipation capacity. In some embodiments, the opening 240-5 of the solder mask layer 210 and the opening 230-3 of the solder mask layer 208 may expose the two terminals of the corresponding through via TV-6 to further improve the heat dissipation capacity of the electronic system 500. In some embodiments, the openings 240-4, 240-5 of the solder mask layer 210 and the opening 230-3 of the solder mask layer 208 may be in many-to-one relationship.

By the opening 230 of the solder mask layer 208 and/or the opening 240 of the solder mask layer 210, the thermal resistance of the heat dissipation paths PH-1, PH-2, PH-3, PH-4, PH-5 and PH-6 can be further reduced to improve the heat dissipation capacity of the electronic system 500.

In some embodiments, the through vias TV may have various types (including various top view areas and various top view shapes) to improve the heat dissipation capability without affecting the signal and power integrity (SI/PI) of the electronic system 500.

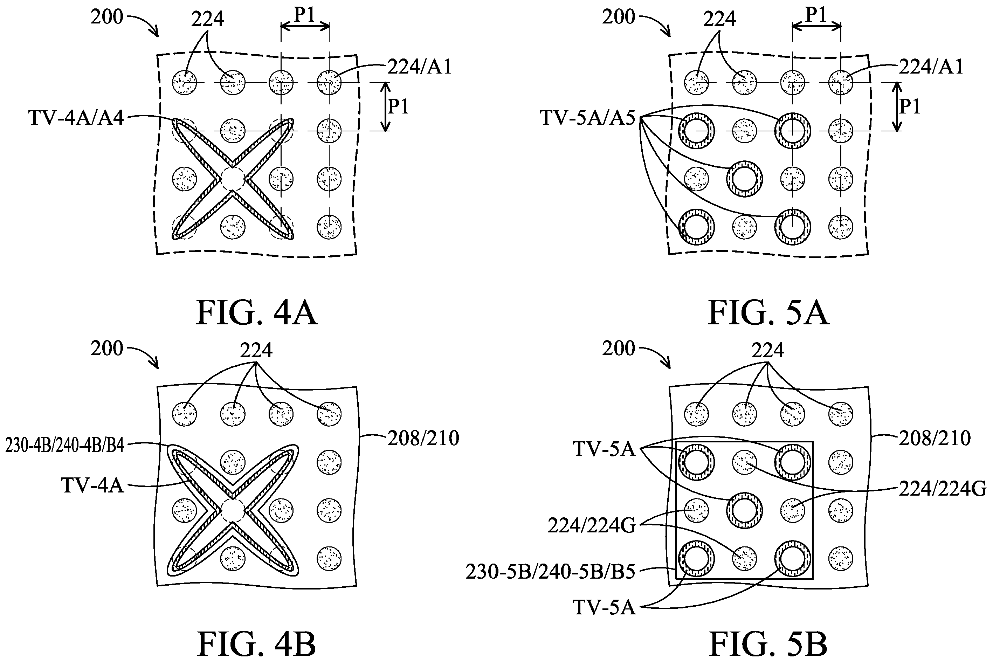

The content below can be read with reference to FIGS. 4A to FIGS. 12B for better understanding. According to the design rule, the pads 224 (including the ground pads 224G, the power pads 224P and the signal pads 224S) of the base 200 may be arranged in an array with a fixed pad pitch. Alternatively, the power pads 224P and the signal pads 224S) of the base 200 may be arranged in an array with different pitches. In addition, each of the ground pads 224G, the power pads 224P and the signal pads 224S may have a fixed pad area in the top view. Furthermore, each of the ground pads 224G, the power pads 224P and the signal pads 224S may have a fixed pad shape (e.g. a circle) in the top view. In some embodiments, the through vias TV coupled to the ground plane 204G may be interposed between the ground pads 224G, the power pads 224P and the signal pads 224S and occupy some positions originally for the ground pads 224G, as shown in the FIG. 1. The through vias TV may be utilized to replace some vertical interconnect structures coupled to the ground pads 224G. In some embodiments, each of the through vias TV may have a through via area in the top view (or in the bottom view) that is equal to or greater than the pad area. In addition, the through via areas of the through vias TV may be different from each other. In some embodiments, each of the through vias TV may have a through via shape in the top view (or in the bottom view) that is equal to or different from the pad shape. In addition, the through via shapes of the through vias TV may be different from each other. In some embodiments, the through via area may be according to a distribution area of the occupied ground pad positions. The occupied ground pad positions are defined as the pad positions originally for the ground pads. In some embodiments, the through via shape may be according to a shape of a distribution area of the occupied ground pad positions. In some embodiments, the through via shape may include a circle, an oval, a criss-cross sign, the letter X, a line shape, or a combination thereof. Since the through vias TV has improved heat dissipation capacity, the through via area may be equal to the occupied ground pad area, and the through via shape may be the same as the occupied ground pad shape. In some embodiments, the through via shape may be the same as the pad shape, and the through via area is greater than the pad area to further improve the heat dissipation capacity of the electronic system 500. In some embodiments, the through via area may be greater than the pad area, and the through via shape may be the same as or different from the pad shape to further improve the heat dissipation capacity of the electronic system 500.

In some embodiments, the openings 230 of the solder mask layer 208 and/or the openings 240 of the solder mask layer 210 may have various types (including the top view area and the top view shape) to strengthen the heat dissipation capability of the electronic system 500. In some embodiments, each of the openings 230 of the solder mask layer 208 (or each of the openings 240 of the solder mask layer 210) may have a shape corresponding to the through via shape of the corresponding through via TV. For example, when the opening 230 of the solder mask layer 208 (or the opening 240 of the solder mask layer 210) expose a single corresponding through via TV, the shape of the opening 230 (or the shape of the opening 240) may correspond to the through via shape of the corresponding through via TV. For example, the shape of the opening 230 of the solder mask layer 208 (or the shape of the opening 240 of the solder mask layer 210) may correspond to a distribution area of the single corresponding through via TV and one or more adjacent ground pads 224G. For example, when the opening 230 of the solder mask layer 208 (or the opening 240 of the solder mask layer 210) expose multiple corresponding through vias TV, the shape of the opening 230 (or the shape of the opening 240) may correspond to a distribution area of the corresponding through vias TV. For example, the shape of the opening 230 (or the shape of the opening 240) may correspond to a distribution area of the single corresponding through vias TV and one or more adjacent ground pads 224G.

FIG. 4A is a schematic top view of a portion of the device-attach region 200CR of the base 200 of the electronic system 500 in accordance with some embodiments of the disclosure, showing the arrangement of a single through via TV-4A and adjacent pads 224 (the pads 224 including the ground pads 224G, the power pads 224P and the signal pads 224S), the single through via TV-4A is coupled to the ground plane 204G. FIG. 4B is a schematic top view of the base 200 of the electronic system 500 of FIG. 4A in accordance with some embodiments of the disclosure, showing the arrangement of an opening 230-4A of the solder mask layer 208 (or the opening 240 of the solder mask layer 210) of the base 200 corresponding to the through via TV-4A. For illustration, the solder mask layer 208 (or the solder mask layer 210) is hidden in FIG. 4A. For illustration, the conductive traces coupled to the power and signal pads and the ground plane 204G coupled to the through vias TV is hidden in FIGS. 4A and 4B.

As shown in FIGS. 4A and 4B, the pads 224 including the ground pads 224G, the power pads 224P and the signal pads 224S may be arranged in an array with a fixed pad pitch P1. In addition, each of the pads 224 may have a fixed pad area A1 in the top view. Furthermore, each of the pads 224 may have a fixed pad shape (e.g., a circle) in the top view. For example, the through via TV-4A coupled to the ground plane 204G may be interposed between the pads 224 and occupy five positions originally for the ground pads 224G. In addition, a distribution area of the occupied positions originally for the ground pads 224G may have the letter X shape. For example, the through via TV-4A may have a through via area A4 in the top view (or in the bottom view) that greater than the pad area A1 to further improve the heat dissipation capacity. For example, the through via TV-4A may have the letter X shape in the top view (or in the bottom view) that different from the pad shape. In some embodiments, the through via area A4 of the through via TV-4A is greater than twice the pad area A1 to further improve the heat dissipation capacity.

As shown in FIGS. 4A and 4B, for example, the single opening 230-4B of the solder mask layer 208 (or an openings 240-4B of the solder mask layer 210) may expose the single corresponding through via TV-4A. In addition, the shape of the opening 230-4B (or the shape of the opening 240-4B) may be the letter X shape corresponding to the through via shape of the corresponding through via TV-4A to further improve the heat dissipation capacity. Furthermore, an area B4 of the opening 230-4B (or an area B4 of the opening 240-4B) may be greater than the through via area A4 in the top view (or in the bottom view) to expose the whole through via TV-4A to further improve the heat dissipation capacity. In some embodiments, the shape of the opening 230-4B (or the shape of the opening 240-4B) may be similar to the shape of the corresponding through via TV-4A. In some embodiments, the shape of the opening 230-4B (or the shape of the opening 240-4B) may be obtained by enlarging the shape of the corresponding through via TV-4A by a certain preset ratio. In some embodiments, the shape of the opening 230-4B (or the shape of the opening 240-4B) is the same as the shape of the corresponding through via TV-4A, but their sizes are different. The embodiment of FIGS. 4A and 4B can improve heat dissipation capacity and reduce interference to surrounding pads.

FIG. 5A is a schematic top view of a portion of the device-attach region 200CR of the base 200 of the electronic system 500 in accordance with some embodiments of the disclosure, showing the arrangement of multiple through vias TV-5A and adjacent pads 224 (the pads 224 including the ground pads 224G, the power pads 224P and the signal pads 224S), the through vias TV-5A are coupled to the ground plane 204G. FIG. 5B is a schematic top view of the base 200 of the electronic system 500 of FIG. 5A in accordance with some embodiments of the disclosure, showing the arrangement of a single opening 230-5B of the solder mask layer 208 (or a single opening 240-5B of the solder mask layer 210) of the base 200 corresponding to the multiple through vias TV-5A. Elements of the embodiments hereinafter, that are the same or similar as those previously described with reference to FIGS. 4A and 4B, are not repeated for brevity. For illustration, the solder mask layer 208 (or the solder mask layer 210) is hidden in FIG. 5A. For illustration, the conductive traces coupled to the power and signal pads and the ground plane 204G coupled to the through vias TV is hidden in FIGS. 5A and 5B. In some embodiments, the shape of the through via TV-5A may be similar or same to the shape of the pad 224. In some embodiments, the through via area A5 of the through via TV-5A is equal to the pad area A1 for ease of manufacturing. In some embodiments, the through via area A5 of the through via TV-5A is greater than the pad area A1 to further improve the heat dissipation capacity.

As shown in FIGS. 5A and 5B, for example, the five through vias TV-5A coupled to the ground plane 204G may be interposed between the pads 224 and occupy five positions originally for the ground pads 224G. In addition, each of the five through vias TV-5A may occupy one position originally for the ground pad 224G. For example, the five through vias TV-5A may be alternately arranged with the pads 224. Each of the through vias TV-5A may have a through via area A5 in the top view (or in the bottom view) that is equal to the pad area A1. Each of the through vias TV-5A may have a circular shape in the top view (or in the bottom view) that is equal to the pad shape (e.g., a circular shape). Since each of the through vias TV-5A has improved heat dissipation capacity, the through via area A5 may be equal to the pad area A1. In addition, the through via shape and the pad shape are both circular. In some embodiments, the through via areas and/or the through via shapes of the through vias TV-5A may be different from each other.

As shown in FIGS. 5A and 5B, for example, the single opening 230-5B of the solder mask layer 208 (or the single opening 240-5B of the solder mask layer 210) may expose the five through vias TV-5A and the four adjacent pads 224 (the four adjacent pads 224 are the ground pads 224G) to further improve the heat dissipation capacity. In addition, the shape of the opening 230-5B (or the shape of the opening 240-5B) may have a square shape corresponding to a distribution area of the corresponding through vias TV-5A to further improve the heat dissipation capacity. Furthermore, an area B5 of the opening 230-5B (or an area B5 of the opening 240-5B) may be at least five times greater than the through via area A5 in the top view (or in the bottom view) to expose the five through vias TV-5A to further improve the heat dissipation capacity. In some embodiments, the shape of the opening 230-5B (or the shape of the opening 240-5B) may be different from the shape of the corresponding through via TV-5A; the shape of the opening 230-5B (or the shape of the opening 240-5B) may be a rectangle and the shape of the through via TV-5A may be a circle. The embodiment of FIGS. 5A and 5B can improve heat dissipation capacity and heat dissipation efficiency.

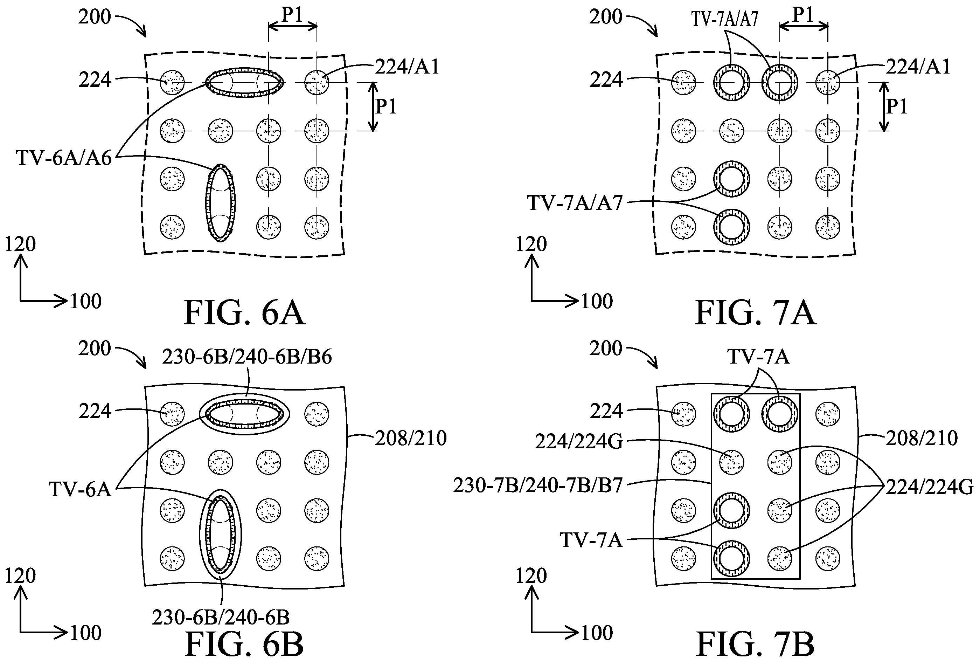

FIG. 6A is a schematic top view of a portion of the device-attach region 200CR of the base 200 of the electronic system 500 in accordance with some embodiments of the disclosure, showing the arrangement of multiple through vias TV-6A (such as two through vias TV-6A) and adjacent pads 224 (the pads 224 including the ground pads 224G, the power pads 224P and the signal pads 224S), through vias TV-6A are the coupled to the ground plane 204G. FIG. 6B is a schematic top view of the base 200 of the electronic system 500 of FIG. 6A in accordance with some embodiments of the disclosure, showing the arrangement of multiple openings 230-6B of the solder mask layer 208 (or multiple openings 240-6B of the solder mask layer 210) of the base 200 corresponding to the multiple through vias TV-6A. Elements of the embodiments hereinafter, that are the same or similar as those previously described with reference to FIGS. 4A, 4B, 5A and 5B, are not repeated for brevity. For illustration, the solder mask layer 208 (or the solder mask layer 210) is hidden in FIG. 6A. For illustration, the conductive traces coupled to the power and signal pads and the ground plane 204G coupled to the through vias TV is hidden in FIGS. 6A and 6B. In some embodiments, the shape of the through via TV-6A may be different from the shape of the pad 224; for example, the shape of the through via TV-6A may be an oval and the shape of the pad 224 may be a circle. In some embodiments, the through via area A6 of the through via TV-6A is greater than the pad area A1 to further improve the heat dissipation capacity. In some embodiments, the through via area A6 of the through via TV-6A is greater than twice the pad area A1 to further improve the heat dissipation capacity.

As shown in FIGS. 6A and 6B, for example, the two through vias TV-6A coupled to the ground plane 204G may be interposed between the pads 224 and occupy four positions originally for the ground pads 224G. In addition, each of the two through vias TV-6A may occupy two positions originally for the ground pads 224G. More specifically, one of the through vias TV-6A may extend along the direction 100 to occupy adjacent two positions originally for the ground pads 224G. Another of the through vias TV-6A may extend along a direction 120 that is perpendicular to the directions 100 and 110 to occupy other adjacent two positions originally for the ground pads 224G. For example, each of the through vias TV-6A may have a through via area A6 in the top view (or in the bottom view) that is greater than the pad area A1. For example, each of the through vias TV-6A may have an oval shape in the top view (or in the bottom view) that is different from the pad shape (e.g., a circular shape). For example, the through via area A6 may be greater than the pad area A1, and the through via shape (e.g., an oval shape) may be different from the pad shape to further improve the heat dissipation capacity. In some embodiments, the through via areas and/or the through via shapes of the through vias TV-6A may be different from each other.

As shown in FIGS. 6A and 6B, for example, each of the openings 230-6B of the solder mask layer 208 (or each of the openings 240-6B of the solder mask layer 210) may expose the single corresponding through via TV-6A, the shape of each of the openings 230-6B (or the shape of each of the openings 240-6B) may have an oval shape corresponding to the through via shape of the corresponding through via TV-6A to further improve the heat dissipation capacity. In some embodiments, the shapes of the openings 230-6B (or the shapes of the openings 240-6B) may be different from each other. Furthermore, an area B6 of the opening 230-6B (or an area B6 of the opening 240-6B) may be greater than the through via area A6 in the top view (or in the bottom view) to expose the corresponding through via TV-6A to further improve the heat dissipation capacity. In some embodiments, the shape of the opening 230-6B (or the shape of the opening 240-6B) may be similar to the shape of the corresponding through via TV-6A. In some embodiments, the shape of the opening 230-6B (or the shape of the opening 240-6B) may be obtained by enlarging the shape of the corresponding through via TV-6A by a certain preset ratio. In some embodiments, the shape of the opening 230-6B (or the shape of the opening 240-6B) is the same as the shape of the corresponding through via TV-6A, but their sizes are different. The embodiment of FIGS. 6A and 6B can improve heat dissipation capacity and reduce interference to surrounding pads.

FIG. 7A is a schematic top view of a portion of the device-attach region 200CR of the base 200 of the electronic system 500 in accordance with some embodiments of the disclosure, showing the arrangement of multiple through vias TV-7A and adjacent pads 224 (the pads 224 including the ground pads 224G, the power pads 224P and the signal pads 224S), the through vias TV-7A are coupled to the ground plane 204G. FIG. 7B is a schematic top view of the base 200 of the electronic system 500 of FIG. 7A in accordance with some embodiments of the disclosure, showing the arrangement of a single opening 230-7B of the solder mask layer 208 (or a single opening 240-7B of the solder mask layer 210) of the base 200 corresponding to the multiple through vias TV-7A. Elements of the embodiments hereinafter, that are the same or similar as those previously described with reference to FIGS. 4A, 4B, 5A, 5B, 6A and 6B, are not repeated for brevity. For illustration, the solder mask layer 208 (or the solder mask layer 210) is hidden in FIG. 7A. For illustration, the conductive traces coupled to the power and signal pads and the ground plane 204G coupled to the through vias TV is hidden in FIGS. 7A and 7B. In some embodiments, the shape of the through via TV-7A may be similar or same to the shape of the pad 224. In some embodiments, the through via area A7 of the through via TV-7A is equal to the pad area A1 for ease of manufacturing. In some embodiments, the through via area A7 of the through via TV-7A is greater than the pad area A1 to further improve the heat dissipation capacity.

As shown in FIGS. 7A and 7B, for example, the four through vias TV-7A coupled to the ground plane 204G may be interposed between the pads 224 and occupy four positions originally for the ground pads 224G. In addition, each of the four through vias TV-7A may occupy one position originally for the ground pad 224G. For example, two of the through vias TV-7A may be arranged in adjacent two positions originally for the ground pads 224G along the direction 100. Other two of the through vias TV-7A may be arranged in other adjacent two positions originally for the ground pads 224G along the direction 120. Each of the through vias TV-7A may have a through via area A7 in the top view (or in the bottom view) that is equal to the pad area A1. Each of the through vias TV-7A may have a circular shape in the top view (or in the bottom view) that is equal to the pad shape (e.g., a circular shape). Since each of the through vias TV-7A has improved heat dissipation capacity, the through via area A7 may be equal to the pad area A1. In addition, the through via shape and the pad shape are both circular. In some embodiments, the through via areas and/or the through via shapes of the through vias TV-7A may be different from each other.

In some embodiments, the single opening 230-7B of the solder mask layer 208 (or the single opening 240-7B of the solder mask layer 210) may expose the four corresponding through vias TV and four adjacent pads 224 (the ground pads 224G). In addition, the shape of the single opening 230-7B (or the shape of the single opening 240-7B) may have a rectangular shape corresponding to a distribution area of the four corresponding through vias TV-7A to further improve the heat dissipation capacity. Furthermore, an area B7 of the opening 230-7B (or an area B7 of the opening 240-7B) may be at least four times greater than the through via area A7 in the top view (or in the bottom view) to expose the four through vias TV-7A to further improve the heat dissipation capacity. In some embodiments, the shape of the opening 230-7B (or the shape of the opening 240-7B) may be different from the shape of the corresponding through via TV-7A; the shape of the opening 230-7B (or the shape of the opening 240-7B) may be a rectangle and the shape of the through via TV-7A may be a circle. The embodiment of FIGS. 7A and 7B can improve heat dissipation capacity and heat dissipation efficiency.

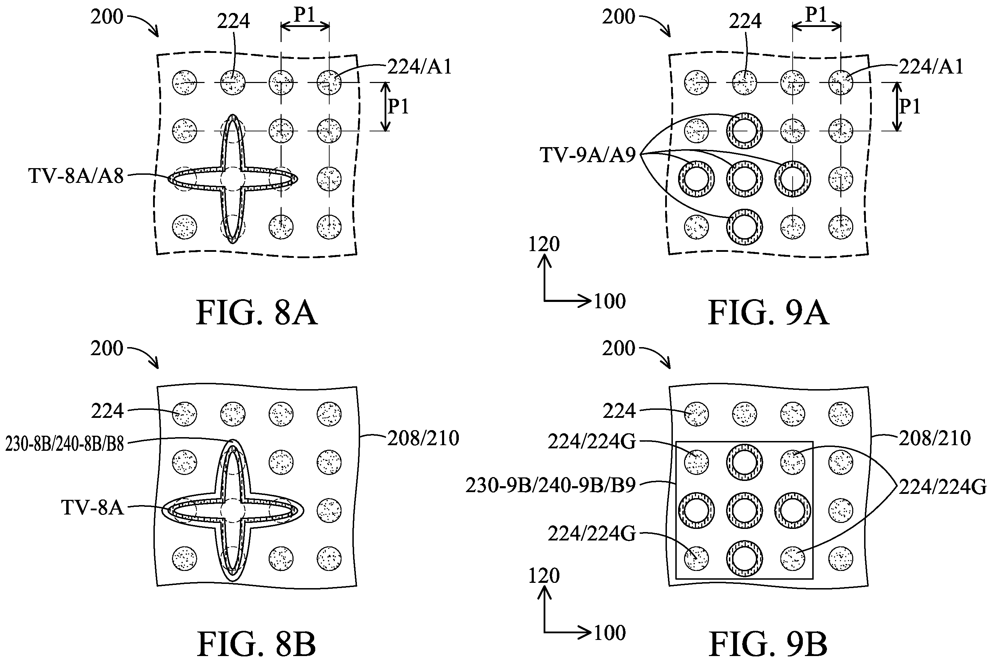

FIG. 8A is a schematic top view of a portion of the device-attach region 200CR of the base 200 of the electronic system 500 in accordance with some embodiments of the disclosure, showing the arrangement of a single through via TV-8A and adjacent pads 224 (the pads 224 including the ground pads 224G, the power pads 224P and the signal pads 224S), the single through via TV-8A is coupled to the ground plane 204G. FIG. 8B is a schematic top view of the base 200 of the electronic system 500 of FIG. 8A in accordance with some embodiments of the disclosure, showing the arrangement of a single opening 230-8B of the solder mask layer 208 (or a single opening 240-8B of the solder mask layer 210) of the base 200 corresponding to the single through via TV-8A. Elements of the embodiments hereinafter, that are the same or similar as those previously described with reference to FIGS. 4A, 4B, 5A, 5B, 6A, 6B, 7A and 7B, are not repeated for brevity. For illustration, the solder mask layer 208 (or the solder mask layer 210) is hidden in FIG. 8A. For illustration, the conductive traces coupled to the power and signal pads and the ground plane 204G coupled to the through vias TV is hidden in FIGS. 8A and 8B. In some embodiments, the shape of the through via TV-8A may be different from the shape of the pad 224; for example, the shape of the through via TV-8A may be a criss-cross sign and the shape of the pad 224 may be a circle. In some embodiments, the through via area A8 of the through via TV-8A is greater than the pad area A1 to further improve the heat dissipation capacity. In some embodiments, the through via area A8 of the through via TV-8A is greater than twice the pad area A1 to further improve the heat dissipation capacity.

As shown in FIGS. 8A and 8B, for example, the single through via TV-8A coupled to the ground plane 204G may be interposed between the pads 224 and occupy five positions originally for the ground pads 224G. In addition, a distribution area of the occupied positions originally for the ground pads 224G may have a criss-cross sign shape. For example, the single through via TV-8A may have a through via area A8 in the top view (or in the bottom view) that greater than the pad area A1 to further improve the heat dissipation capacity. For example, the through via TV-8A may have a criss-cross sign shape in the top view (or in the bottom view) that different from the pad shape.

As shown in FIGS. 8A and 8B, for example, the single opening 230-8B of the solder mask layer 208 (or the single openings 240-8B of the solder mask layer 210) may expose the single corresponding through via TV-8A. In addition, the shape of the opening 230-8B (or the shape of the opening 240-8B) may be a criss-cross sign shape corresponding to the through via shape of the corresponding through via TV-8A to further improve the heat dissipation capacity. Furthermore, an area B8 of the opening 230-8B (or an area B8 of the opening 240-8B) may be greater than the through via area A8 in the top view (or in the bottom view) to expose the whole through vias TV-8A to further improve the heat dissipation capacity. In some embodiments, the shape of the opening 230-8B (or the shape of the opening 240-8B) may be similar to the shape of the corresponding through via TV-8A. In some embodiments, the shape of the opening 230-8B (or the shape of the opening 240-8B) may be obtained by enlarging the shape of the corresponding through via TV-8A by a certain preset ratio. In some embodiments, the shape of the opening 230-8B (or the shape of the opening 240-8B) is the same as the shape of the corresponding through via TV-8A, but their sizes are different. The embodiment of FIGS. 8A and 8B can improve heat dissipation capacity and reduce interference to surrounding pads.

FIG. 9A is a schematic top view of a portion of the device-attach region 200CR of the base 200 of the electronic system 500 in accordance with some embodiments of the disclosure, showing the arrangement of multiple through vias TV-9A and adjacent pads 224 (the pads 224 including the ground pads 224G, the power pads 224P and the signal pads 224S), the through vias TV-9A are coupled to the ground plane 204G. FIG. 9B is a schematic top view of the base 200 of the electronic system 500 of FIG. 9A in accordance with some embodiments of the disclosure, showing the arrangement of a single opening 230-9B of the solder mask layer 208 (or a single opening 240-9B of the solder mask layer 210) of the base 200 corresponding to the multiple through vias TV-9A. Elements of the embodiments hereinafter, that are the same or similar as those previously described with reference to FIGS. 4A, 4B, 5A, 5B, 6A, 6B, 7A, 7B, 8A and 8B, are not repeated for brevity. For illustration, the solder mask layer 208 (or the solder mask layer 210) is hidden in FIG. 9A. For illustration, the conductive traces coupled to the power and signal pads and the ground plane 204G coupled to the through vias TV is hidden in FIGS. 9A and 9B. In some embodiments, the shape of the through via TV-9A may be similar or same to the shape of the pad 224. In some embodiments, the through via area A9 of the through via TV-9A is equal to the pad area A1 for ease of manufacturing. In some embodiments, the through via area A9 of the through via TV-9A is greater than the pad area A1 to further improve the heat dissipation capacity.

As shown in FIGS. 9A and 9B, for example, the five through vias TV-9A coupled to the ground plane 204G may be interposed between the pads 224 and occupy five positions originally for the ground pads 224G. In addition, each of the two through vias TV-9A may occupy one position originally for the ground pad 224G. For example, the five through vias TV-5A may be arranged in adjacent five positions originally for the ground pads 224G along the directions 100 and 120. In addition, the distribution area of the five occupied positions originally for the ground pads 224G may have a criss-cross sign shape. Each of the through vias TV-9A may have a through via area A9 in the top view (or in the bottom view) that is equal to the pad area A1. Each of the through vias TV-9A may have a circular shape in the top view (or in the bottom view) that is equal to the pad shape (e.g., a circular shape). Since each of the through vias TV-9A has improved heat dissipation capacity, the through via area A9 may be equal to the pad area A1. In addition, the through via shape and the pad shape are both circular. In some embodiments, the through via areas and/or the through via shapes of the through vias TV-9A may be different from each other.

As shown in FIGS. 9A and 9B, for example, the single opening 230-9B of the solder mask layer 208 (or the single opening 240-9B of the solder mask layer 210) may exposed the five through vias TV-9A and four adjacent pads 224 (the ground pads 224G). In addition, the shape of the opening 230-9B (or the shape of the opening 240-9B) may be a square shape corresponding to a distribution area of the corresponding through vias TV-9A to further improve the heat dissipation capacity. Furthermore, an area B9 of the opening 230-9B (or an area B9 of the opening 240-9B) may be at least five times greater than the through via area A9 in the top view (or in the bottom view) to expose the five through vias TV-9A to further improve the heat dissipation capacity. In some embodiments, the shape of the opening 230-9B (or the shape of the opening 240-9B) may be different from the shape of the corresponding through via TV-9A; the shape of the opening 230-9B (or the shape of the opening 240-9B) may be a rectangle and the shape of the through via TV-9A may be a circle. The embodiment of FIGS. 9A and 9B can improve heat dissipation capacity and heat dissipation efficiency.

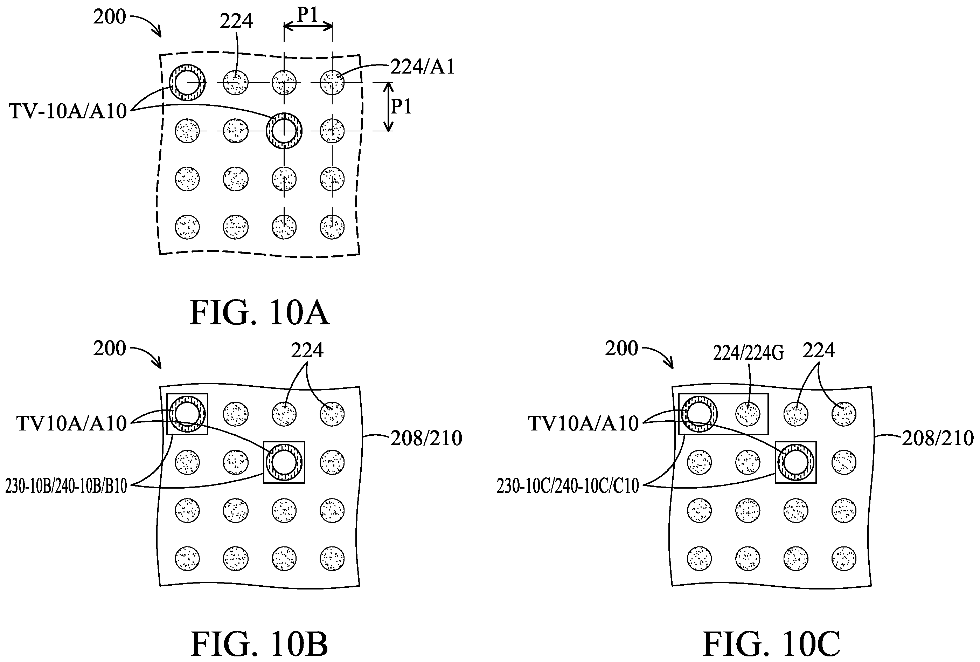

FIG. 10A is a schematic top view of a portion of the device-attach region 200CR of the base 200 of the electronic system 500 in accordance with some embodiments of the disclosure, showing the arrangement of multiple through vias TV-10A and adjacent pads 224 (the pads 224 including the ground pads 224G, the power pads 224P and the signal pads 224S), the through vias TV-10A are coupled to the ground plane 204G. FIG. 10B and 10C are schematic top views of the base 200 of the electronic system 500 of FIG. 10A in accordance with some embodiments of the disclosure, showing the arrangement of multiple openings 230-10B and 230-10C of the solder mask layer 208 (or multiple openings 240-10B and 240-10C of the solder mask layer 210) of the base 200 corresponding to the multiple through vias TV-10A. Elements of the embodiments hereinafter, that are the same or similar as those previously described with reference to FIGS. 4A, 4B, 5A, 5B, 6A, 6B, 7A, 7B, 8A, 8B, 9A and 9B, are not repeated for brevity. For illustration, the solder mask layer 208 (or the solder mask layer 210) is hidden in FIG. 10A. For illustration, the conductive traces coupled to the power and signal pads and the ground plane 204G coupled to the through vias TV is hidden in FIGS. 10A and 10B. In some embodiments, the shape of the through via TV-10A may be similar or same to the shape of the pad 224. In some embodiments, the through via area A10 of the through via TV-10A is equal to the pad area A1 for ease of manufacturing. In some embodiments, the through via area A10 of the through via TV-10A is greater than the pad area A1 to further improve the heat dissipation capacity.

As shown in FIG. 10A, for example, the two through vias TV-10A coupled to the ground plane 204G may be interposed between the pads 224 and occupy four positions originally for the ground pads 224G. In addition, each of the two through vias TV-10A may occupy one position originally for the ground pad 224G. Each of the through vias TV-10A may have a through via area A10 in the top view (or in the bottom view) that is equal to the pad area A1. Each of the through vias TV-10A may have a circular shape in the top view (or in the bottom view) that is equal to the pad shape (e.g., a circular shape). Since each of the through vias TV-10A has improved heat dissipation capacity, the through via area A10 may be equal to the pad area A1. In addition, the through via shape and the pad shape are both circular. In some embodiments, the through via areas and/or the through via shapes of the through vias TV-10A may be different from each other.

As shown in FIGS. 10A and 10B, for example, each of the openings 230-10B of the solder mask layer 208 (or each of the openings 240-10B of the solder mask layer 210) may expose the single corresponding through via TV-10A, the shape of each of the openings 230-10B (or the shape of each of the openings 240-10B) may have a square shape corresponding to the through via shape of the corresponding through via TV-10A to further improve the heat dissipation capacity. In some embodiments, the shapes of the openings 230-10B (or the shapes of the openings 240-10B) may be different from each other. Furthermore, an area B10 of the opening 230-10B (or an area B10 of the opening 240-10B) may be greater than the through via area A10 in the top view (or in the bottom view) to expose the corresponding through via TV-10A to further improve the heat dissipation capacity. In some embodiments, the shape of the opening 230-10B (or the shape of the opening 240-10B) may be different from the shape of the corresponding through via TV-10A; the shape of the opening 230-10B (or the shape of the opening 240-10B) may be a rectangle and the shape of the through via TV-10A may be a circle. In some embodiments, the area B10 of the opening 230-10B (or the area B10 of the opening 240-10B) may be less than twice the pad area A1 to reduce interference with surrounding pads.

As shown in FIGS. 10A and 10C, for example, each of the openings 230-10C of the solder mask layer 208 (or each of the openings 240-10C of the solder mask layer 210) may expose the single corresponding through via TV-10A. One opening 230-10C of the solder mask layer 208 may further expose one adjacent pad 224 (the ground pad 224G), and the shape of this opening 230-10C may be a rectangle. In some embodiments, the area C10 of one of the opening 230-10C (or the area C10 of one of the opening 240-10C) may be greater than twice the pad area A1 to further improve the heat dissipation capacity. The shape of each of the openings 230-10C (or the shape of each of the openings 240-10C) may correspond to a shape of a distribution area of the corresponding two through vias TV-10A to further improve the heat dissipation capacity. In some embodiments, the shapes of the openings 230-10C (or the shapes of the openings 240-10C) may be different from each other. Furthermore, an area C10 of the opening 230-10C (or an area C10 of the opening 240-10C) may be greater than the through via area A10 in the top view (or in the bottom view) to expose the corresponding through via TV-10A to further improve the heat dissipation capacity. In some embodiments, the shape of the opening 230-10C (or the shape of the opening 240-10C) may be different from the shape of the corresponding through via TV-10A; the shape of the opening 230-10C (or the shape of the opening 240-10C) may be a rectangle and the shape of the through via TV-10A may be a circle. In some embodiments, the area C10 of the opening 230-10C (or the area C10 of the opening 240-10C) may be greater than twice the pad area A1 to further improve the heat dissipation capacity.

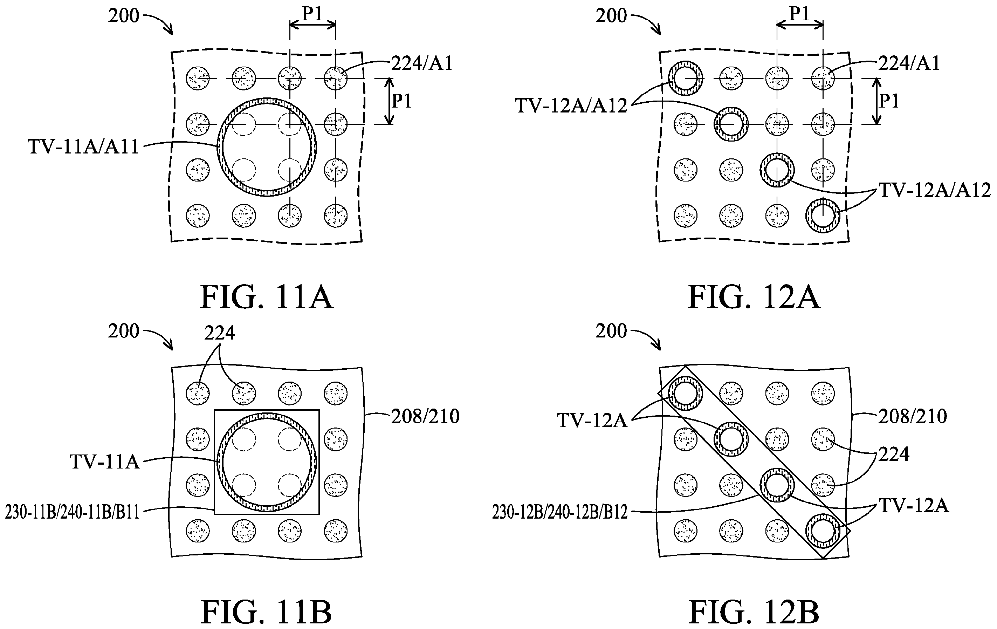

FIG. 11A is a schematic top view of a portion of the device-attach region 200CR of the base 200 of the electronic system 500 in accordance with some embodiments of the disclosure, showing the arrangement of a single through via TV-11A and adjacent pads 224 (the pads 224 including the ground pads 224G, the power pads 224P and the signal pads 224S), the single through via TV-11A is coupled to the ground plane 204G. FIG. 11B is a schematic top view of the base 200 of the electronic system 500 of FIG. 11A in accordance with some embodiments of the disclosure, showing the arrangement of a single opening 230-11B of the solder mask layer 208 (or a single opening 240-11B of the solder mask layer 210) of the base 200 corresponding to the single through via TV-11A. Elements of the embodiments hereinafter, that are the same or similar as those previously described with reference to FIGS. 4A, 4B, 5A, 5B, 6A, 6B, 7A, 7B, 8A, 8B, 9A, 9B, 10A, 10B and 10C, are not repeated for brevity. For illustration, the solder mask layer 208 (or the solder mask layer 210) is hidden in FIG. 11A. For illustration, the conductive traces coupled to the power and signal pads and the ground plane 204G coupled to the through vias TV is hidden in FIGS. 11A and 11B.

As shown in FIGS. 11A and 11B, for example, the single through via TV-11A coupled to the ground plane 204G may be interposed between the pads 224 and occupy four adjacent positions originally for the ground pads 224G. In addition, a distribution area of the occupied four positions originally for the ground pads 224G may have a circular shape. For example, the through vias TV-11A may have a circular shape in the top view (or in the bottom view) that is equal to the pad shape (e.g., a circular shape). In some embodiments, the through via TV-11A and the pad 224 are both circular, but their sizes are different. In addition, the through vias TV-11A may have a through via area A11 in the top view (or in the bottom view) that is greater than the pad area A1 to further improve the heat dissipation capacity. In some embodiments, the through via area A11 of the through via TV-11A is greater than four times the pad area A1 to further improve the heat dissipation capacity.

As shown in FIGS. 11A and 11B, for example, the single opening 230-11B of the solder mask layer 208 (or the single openings 240-11B of the solder mask layer 210) may expose the single corresponding through via TV-11A. In addition, the shape of the opening 230-11B (or the shape of the opening 240-11B) may be a square shape corresponding to a shape of a distribution area of the corresponding through via TV-11A to further improve the heat dissipation capacity. Furthermore, an area B11 of the opening 230-11B (or an area B11 of the opening 240-11B) may be greater than the through via area A11 in the top view (or in the bottom view) to expose the corresponding through via TV-11A to further improve the heat dissipation capacity. In some embodiments, the shape of the opening 230-11B (or the shape of the opening 240-11B) may be different from the shape of the corresponding through via TV-11A; the shape of the opening 230-11B (or the shape of the opening 240-11B) may be a rectangle and the shape of the through via TV-11A may be a circle. The embodiment of FIGS. 11A and 11B can improve heat dissipation capacity and heat dissipation efficiency.

FIG. 12A is a schematic top view of a portion of the device-attach region 200CR of the base 200 of the electronic system 500 in accordance with some embodiments of the disclosure, showing the arrangement of multiple through vias TV-12A and adjacent pads 224 (the pads 224 including the ground pads 224G, the power pads 224P and the signal pads 224S), the through vias TV-12A are coupled to the ground plane 204G. FIG. 12B is a schematic top view of the base 200 of the electronic system 500 of FIG. 12A in accordance with some embodiments of the disclosure, showing the arrangement of a single opening 230-12B of the solder mask layer 208 (or a single opening 240-12B of the solder mask layer 210) of the base 200 corresponding to the multiple through vias TV-12A. Elements of the embodiments hereinafter, that are the same or similar as those previously described with reference to FIGS. 4A, 4B, 5A, 5B, 6A, 6B, 7A, 7B, 8A, 8B, 9A, 9B, 10A, 10B, 10C, 11A and 11B, are not repeated for brevity. For illustration, the solder mask layer 208 (or the solder mask layer 210) is hidden in FIG. 12A. For illustration, the conductive traces coupled to the power and signal pads and the ground plane 204G coupled to the through vias TV is hidden in FIGS. 12A and 12B. In some embodiments, the shape of the through via TV-12A may be similar or same to the shape of the pad 224. In some embodiments, the through via area A12 of the through via TV-12A is equal to the pad area A1 for ease of manufacturing. In some embodiments, the through via area A12 of the through via TV-12A is greater than the pad area A1 to further improve the heat dissipation capacity.

As shown in FIGS. 12A and 12B, for example, the four through vias TV-12A coupled to the ground plane 204G may be interposed between the pads 224 and occupy four positions originally for the ground pads 224G. In addition, each of the four through vias TV-12A may occupy one position originally for the ground pad 224G. For example, the four through vias TV-12A may be arranged in adjacent four positions originally for the ground pads 224G along the diagonal line of the pad array. In addition, the distribution area of the four occupied positions originally for the ground pads 224G may have a line shape. Each of the through vias TV-12A may have a through via area A12 in the top view (or in the bottom view) that is equal to the pad area A1. Each of the through vias TV-12A may have a circular shape in the top view (or in the bottom view) that is equal to the pad shape (e.g., a circular shape). Since each of the through vias TV-12A has improved heat dissipation capacity, the through via area A12 may be equal to the pad area A1. In addition, the through via shape and the pad shape are both circular. In some embodiments, the through via areas and/or the through via shapes of the through vias TV-12A may be different from each other.

As shown in FIGS. 12A and 12B, for example, the single opening 230-12B of the solder mask layer 208 (or the single opening 240-12B of the solder mask layer 210) may exposed the four through vias TV-12A. In addition, the shape of the opening 230-12B (or the shape of the opening 240-12B) may be a line shape (or a rectangle) corresponding to a through via shape (e.g., a line shape) of the corresponding through vias TV-12A to further improve the heat dissipation capacity. Furthermore, an area B12 of the opening 230-12B (or an area B12 of the opening 240-12B) may be at least four times greater than the through via area A12 in the top view (or in the bottom view) to expose the four through via TV-12A to further improve the heat dissipation capacity. In some embodiments, the shape of the opening 230-12B (or the shape of the opening 240-12B) may be different from the shape of the corresponding through via TV-12A; the shape of the opening 230-12B (or the shape of the opening 240-12B) may be a rectangle and the shape of the through via TV-12A may be a circle. The embodiment of FIGS. 12A and 12B can improve heat dissipation capacity and reduce interference to surrounding pads.

Embodiments provide an electronic system. The electronic system includes a base and a semiconductor device. The base having a device-attach region includes a build-up layer structure, a vertical interconnect structure, a through via and a top ground plane. The vertical interconnect structure and the through via are formed passing through the build-up layer structure and located in the device-attach region. The vertical interconnect structure (e.g., the high-density interconnect (HDI)) includes at least one buried via and at least one blind via electrically coupled to the buried via. The top ground plane is disposed on the top surface of the build-up layer structure and located in the device-attach region. The semiconductor device having a conductive structure is mounted on the device-attach region of the base. The through via, the conductive structure of the semiconductor device and the vertical interconnect structure corresponding to the conductive structure of the semiconductor device are coupled to the top ground plane. The vertical interconnect structure and the conductive structure of the semiconductor device are in contact with a first portion of the top ground plane. In addition, the through via is in contact with the second portion of the top ground plane. In some embodiments, the base further includes a bottom ground plane disposed on the bottom surface of the build-up layer structure. The two terminals of the through via may be in contact with the top ground layer and the bottom ground plane.

The electronic system may use one or more through vias connected between the top ground plane and the bottom ground plane to replace some vertical interconnect structures. The through vias directly passing through the build-up layer structure may provide shorter heat dissipation paths for the semiconductor device than the vertical interconnect structures. The through vias may form heat dissipation paths from the top of the base to the bottom of the base. Heat generated from the semiconductor device may be quickly transmitted to the ambient air along the heat dissipation paths. In addition, the internal conductive layers of the build-up layer structure coupled to the through vias may form additional heat dissipation paths from the top of the base to the sides of the base. Heat generated from the semiconductor device may be quickly transmitted to the ambient air along the additional heat dissipation paths.

In some embodiments, the base may further include the top solder mask layer disposed on the top ground plane and the bottom solder mask layer disposed on the bottom ground plane. At least one of the top solder mask layer and the bottom solder mask layer may optionally have the opening to expose at least one terminal of the through via to further improve the heat dissipation efficiency. In some embodiments, the through vias TV may have various types (including the top view area and the top view shape) to improve the heat dissipation capability without affecting the signal and power integrity (SI/PI) of the electronic system. In some embodiments, the openings of the top solder mask layer and/or the openings of the bottom solder mask layer may have various types (including the top view area and the top view shape) to strengthen the heat dissipation capability of the electronic system.

## Claims

1. An electronic system (500), comprising:
a base (200) having a device-attach region (200CR), wherein the base (200) comprises:
a build-up layer structure (202);
a vertical interconnect structure (HDI, HDI-2, HDI-3, HDI-4, HDI-5, HDI-6, HDI-7, HDI-8, HDI-9, HDI-10, HDI-11) passing through the build-up layer structure (202) and located in the device-attach region (200CR), wherein the vertical interconnect structure (HDI, HDI-2, HDI-3, HDI-4, HDI-5, HDI-6, HDI-7, HDI-8, HDI-9, HDI-10, HDI-11) comprises at least one buried via (212) and at least one blind via (214) electrically coupled to the buried via (212); and
a first through via (TV, TV-1, TV-2, TV-3, TV-4, TV-5, TV-6, TV-4A, TV-5A, TV-6A, TV-7A, TV-8A, TV-9A, TV-10A, TV-11A, TV-12A) passing through the build-up layer structure (202) and located in the device-attach region (200CR), wherein the first through via (TV, TV-1, TV-2, TV-3, TV-4, TV-5, TV-6, TV-4A, TV-5A, TV-6A, TV-7A, TV-8A, TV-9A, TV-10A, TV-11A, TV-12A) is a straight through via (TV, TV-1, TV-2, TV-3, TV-4, TV-5, TV-6, TV-4A, TV-5A, TV-6A, TV-7A, TV-8A, TV-9A, TV-10A, TV-11A, TV-12A); and
a semiconductor device (300) mounted on the device-attach region (200CR) of the base (200).
wherein the base (200) further comprises a first conductive layer (204) disposed on the top surface (202t) of the build-up layer structure (202), and a first solder mask layer (208) disposed on the first conductive layer (204), wherein the first conductive layer (204) comprises a first ground plane (204G, 204G1, 204G2, 204G3, 204G4, 204G5, 204G6) comprising at least one ground pad (224G, 224G1, 224G2, 224G3, 224G4, 224G5) in the device-attach region (200CR), and
wherein the first solder mask layer (208) has a first opening (230, 230-1, 230-2, 230-3, 230-4A, 230-4B, 230-5B, 230-6B, 230-8B, 230-9B, 230-10B, 230-10C, 230-11B, 230-12B) to expose the first through via (TV-1, TV-2, TV-3, TV-4, TV-5, TV-6, TV-4A, TV-5A, TV-6A, TV-7A, TV-8A, TV-9A, TV-10A, TV-11A, TV-12A) and a portion of the first ground plane (204G, 204G1, 204G2, 204G3, 204G4, 204G5, 204G6) adjacent to the first through via (TV, TV-1, TV-2, TV-3, TV-4, TV-5, TV-6, TV-4A, TV-5A, TV-6A, TV-7A, TV-8A, TV-9A, TV-10A, TV-11A, TV-12A).

2. The electronic system (500) as claimed in claim 1, wherein the first ground plane (204G, 204G1, 204G2, 204G3, 204G4, 204G5, 204G6, 206G, 206G1, 206G2, 206G3, 206G4, 206G5, 206G6) is disposed on a top surface (202t) of the build-up layer structure (202) and located in the device-attach region (200CR); and
wherein the first through via (TV, TV-1, TV-2, TV-3, TV-4, TV-5, TV-6, TV-4A, TV-5A, TV-6A, TV-7A, TV-8A, TV-9A, TV-10A, TV-11A, TV-12A) is coupled to the first ground plane (204G, 204G1, 204G2, 204G3, 204G4, 204G5, 204G6).

3. The electronic system (500) as claimed in claim 2, wherein the semiconductor device (300) is mounted on the device-attach region (200CR) of the base (200) by a plurality of conductive structures (322, 322G1, 322G2, 322G3, 322G4, 322G5, 322P1, 322P2, 322P3, 322S1, 322S2, 322S3), and
wherein the plurality of conductive structures (322, 322G1, 322G2, 322G3, 322G4, 322G5, 322P1, 322P2, 322P3, 322S1, 322S2, 322S3) comprise at least one grounded conductive structure (322, 322G1, 322G2, 322G3, 322G4, 322G5) disposed in contact with the ground pad (224G, 224G1, 224G2, 224G3, 224G4, 224G5), and wherein the ground pad (224G, 224G1, 224G2, 224G3, 224G4, 224G5) is disposed in contact with the vertical interconnect structure (HDI, HDI-2, HDI-3, HDI-4, HDI-5, HDI-6, HDI-7, HDI-8, HDI-9, HDI-10, HDI-11) corresponding to the conductive structure (322, 322G1, 322G2, 322G3, 322G4, 322G5)of the semiconductor device (300).

4. The electronic system (500) as claimed in claim 3, wherein the ground pad (224G, 224G1, 224G2, 224G3, 224G4, 224G5) is offset from the first through via (TV, TV-1, TV-2, TV-3, TV-4, TV-5, TV-6, TV-4A, TV-5A, TV-6A, TV-7A, TV-8A, TV-9A, TV-10A, TV-11A, TV-12A) along a first direction (100), wherein the first direction (100) is substantially parallel to the top surface (200t) of the base (200).

5. The electronic system (500) as claimed in claim 4, wherein the ground pad (224G, 224G1, 224G2, 224G3, 224G4, 224G5) and a portion of the first ground plane (204G, 204G1, 204G2, 204G3, 204G4, 204G5, 204G6) adjacent to the ground pad (224G, 224G1, 224G2, 224G3, 224G4, 224G5) are exposed from the first opening (230, 230-1, 230-2, 230-3, 230-4A, 230-4B, 230-5B, 230-6B, 230-8B, 230-9B, 230-10B, 230-10C, 230-11B, 230-12B).

6. The electronic system (500) as claimed in claim 1, wherein the at least one grounded conductive structure (322, 322G1, 322G2, 322G3, 322G4, 322G5) adjacent to the first through via (TV, TV-1, TV-2, TV-3, TV-4, TV-5, TV-6, TV-4A, TV-5A, TV-6A, TV-7A, TV-8A, TV-9A, TV-10A, TV-11A, TV-12A) is exposed by the first opening (230, 230-1, 230-2, 230-3, 230-4A, 230-4B, 230-5B, 230-6B, 230-8B, 230-9B, 230-10B, 230-10C, 230-11B, 230-12B).

7. The electronic structure as claimed in claim 1, wherein the base (200) further comprises:
a second conductive layer (206) disposed on a bottom surface (202B) of the build-up layer structure (202), wherein the second conductive layer (206) comprises a second ground plane (206G, 206G1, 206G2, 206G3, 206G4, 206G5, 206G6) in contact with the first through via (TV-1, TV-2, TV-3, TV-4, TV-5, TV-6, TV-4A, TV-5A, TV-6A, TV-7A, TV-8A, TV-9A, TV-10A, TV-11A, TV-12A), and
a second solder mask layer (210) disposed on the second conductive layer (206);
wherein the second solder mask layer (210) has a second opening ( 240, 240-1, 240-2, 240-3, 240-4, 240-4B, 240-5, 240-5B, 240-6B, 240-8B, 240-9B, 240-10B, 240-10C, 240-11B, 240-12B) to expose the first through via (TV-1, TV-2, TV-3, TV-4, TV-5, TV-6, TV-4A, TV-5A, TV-6A, TV-7A, TV-8A, TV-9A, TV-10A, TV-11A, TV-12A).

8. The electronic system (500) as claimed in claim 1, wherein
the first conductive layer (204) comprises base pads (224, 224G, 224P, 224S, 224G1, 224G2, 224G3, 224G4, 224G5, 224P1, 224P2, 224P3, 224S1, 224S2, 224S3) comprising the ground pad (224G, 224G1, 224G2, 224G3, 224G4, 224G5),
each of the base pads (224, 224G, 224P, 224S, 224G1, 224G2, 224G3, 224G4, 224G5, 224P1, 224P2, 224P3, 224S1, 224S2, 224S3) has a pad (224) shape and a pad area (Al), and
the first through via (TV, TV-1, TV-2, TV-3, TV-4, TV-5, TV-6, TV-4A, TV-5A, TV-6A, TV-7A, TV-8A, TV-9A, TV-10A, TV-11A, TV-12A) is interposed between the pads (224, 224G, 224P, 224S, 224G1, 224G2, 224G3, 224G4, 224G5, 224P1, 224P2, 224P3, 224S1, 224S2, 224S3) and has a first through via shape and a first through via area (A4, A5, A6, A7, A8, A9, A10, A11, A12).

9. The electronic system (500) as claimed in claim 8, wherein the first through via (TV, TV-1, TV-2, TV-3, TV-4, TV-5, TV-6, TV-5A, TV-7A, TV-9A, TV-10A, TV-11A, TV-12A) shape is the same as the pad (224) shape, and wherein the first through via area (A4, A5, A6, A7, A8, A9, A10, A11, A12) is greater than or same to the pad area (A1).

10. The electronic system (500) as claimed in claim 8, wherein the through via (TV, TV-1, TV-2, TV-3, TV-4, TV-5, TV-6, TV-4A, TV-5A, TV-6A, TV-7A, TV-8A, TV-9A, TV-10A, TV-11A, TV-12A) shape comprises a circle, an oval, a criss-cross sign, the letter X, a line shape, or a combination thereof.

11. The electronic system (500) as claimed in claim 1, wherein the build-up layer structure (202) further comprises:
a second through via (TV, TV-1, TV-2, TV-3, TV-4, TV-5, TV-6, TV-5A, TV-6A, TV-7A, TV-9A, TV-10A, TV-12A) passing through the build-up layer structure (202) and located in the device-attach region (200CR), wherein the second through via (TV, TV-1, TV-2, TV-3, TV-4, TV-5, TV-6, TV-5A, TV-6A, TV-7A, TV-9A, TV-10A, TV-12A) has a second through via area (A5, A6, A7, A9, A10, A12) and a second through via shape.

12. The electronic system (500) as claimed in claim 10, wherein the first solder mask layer (208, 210) comprises a third opening (230-6B, 230-10B, 240-6B, 240-10B, 230-10C) to expose the second through via (TV-6A, TV-10A), wherein a first shape of the first opening (230-6B, 230-10B, 240-6B, 240-10B) corresponds to the first through via (TV-6A, TV-10A) shape, and a second shape of the third opening (230-6B, 230-10B, 240-6B, 240-10B) corresponds to the second through via (TV-6A, TV-10A) shape.

13. The electronic system (500) as claimed in claim 8, wherein the first through via (TV-4A, TV-6A, TV-8A) shape is different from the pad (224) shape.

14. The electronic system (500) as claimed in claim 12, wherein an area (B4, B6, B8) of the first opening ( 230-4B, 230-6B, 230-8B, 240-4B, 240-6B, 240-8B) is greater than twice an area of the pad (224); or
wherein the shape of the first opening (230-4B, 230-6B, 230-8B, 240-4B, 240-6B, 240-8B) is same as the shape of the first through via (TV-4A, TV-6A, TV-8A).

15. The electronic system (500) as claimed in claim 1, wherein the semiconductor device (300) is mounted on the device-attach region (200CR) of the base (200) by the at least one grounded conductive structure (322, 322G1, 322G2, 322G3, 322G4, 322G5)connecting to the first through via (TV-1, TV-2, TV-3, TV-4, TV-5, TV-6, TV-4A, TV-5A, TV-6A, TV-7A, TV-8A, TV-9A, TV-10A, TV-11A, TV-12A), and wherein the at least one grounded conductive structure (322, 322G1, 322G2, 322G3, 322G4, 322G5) is disposed directly above the vertical interconnect structure (HDI, HDI-2, HDI-3, HDI-4, HDI-5, HDI-6, HDI-7, HDI-8, HDI-9, HDI-10, HDI-11) rather than above the first through via (TV-1, TV-2, TV-3, TV-4, TV-5, TV-6, TV-4A, TV-5A, TV-6A, TV-7A, TV-8A, TV-9A, TV-10A, TV-11A, TV-12A).

## Patentansprüche

1. Elektronisches System (500), umfassend:
eine Basis (200), die eine Vorrichtungs-Befestigungsregion (200CR) aufweist, wobei die Basis (200) Folgendes umfasst:
eine Aufbauschichtstruktur (202);
eine vertikale Verbindungsstruktur (HDI, HDI-2, HDI-3, HDI-4, HDI-5, HDI-6, HDI-7, HDI-8, HDI-9, HDI-10, HDI-11), die durch die Aufbauschichtstruktur (202) verläuft und sich in der Vorrichtungs-Befestigungsregion (200CR) befindet, wobei die vertikale Verbindungsstruktur (HDI, HDI-2, HDI-3, HDI-4, HDI-5, HDI-6, HDI-7, HDI-8, HDI-9, HDI-10, HDI-11) mindestens ein vergrabenes Loch (212) und mindestens ein mit dem vergrabenen Loch (212) elektrisch gekoppeltes Sackloch ( 214) umfasst; und
ein erstes Durchgangsloch (TV, TV-1, TV-2, TV-3, TV-4, TV-5, TV-6, TV-4A, TV-5A, TV-6A, TV-7A, TV-8A, TV-9A, TV-10A, TV-11A, TV-12A), das durch die Aufbauschichtstruktur (202) verläuft und sich in der Vorrichtungs-Befestigungsregion (200CR) befindet, wobei das erste Durchgangsloch (TV, TV-1, TV-2, TV-3, TV-4, TV-5, TV-6, TV-4A, TV-5A, TV-6A, TV-7A, TV-8A, TV-9A, TV-10A, TV-11A, TV-12A) ein gerades Durchgangsloch (TV, TV-1, TV-2, TV-3, TV-4, TV-5, TV-6, TV-4A, TV-5A, TV-6A, TV-7A, TV-8A, TV-9A, TV-10A, TV-11A, TV-12A) ist; und
eine Halbleitervorrichtung (300), die auf der Vorrichtungs-Befestigungsregion (200CR) der Basis (200) montiert ist.
wobei die Basis (200) ferner eine erste leitende Schicht (204) umfasst, die auf der oberen Oberfläche (202t) der Aufbauschichtstruktur (202) angeordnet ist, und eine erste Lötmaskenschicht (208), die auf der ersten leitenden Schicht (204) angeordnet ist, wobei die erste leitende Schicht (204) eine erste Masseebene (204G, 204G1, 204G2, 204G3, 204G4, 204G5, 204G6) umfasst, die mindestens ein Massepolster (224G, 224G1, 224G2, 224G3, 224G4, 224G5) in der Vorrichtungs-Befestigungsregion (200CR) umfasst, und
wobei die erste Lötmaskenschicht (208) eine erste Öffnung (230, 230-1, 230-2, 230-3, 230-4A, 230-4B, 230-5B, 230-6B, 230-8B, 230-9B, 230-10B, 230-10C, 230-11B, 230-12B) aufweist, um das erste Durchgangsloch (TV-1, TV-2, TV-3, TV-4, TV-5, TV-6, TV-4A, TV-5A, TV-6A, TV-7A, TV-8A, TV-9A, TV-10A, TV-11A, TV-12A) und einen Abschnitt der ersten Masseebene (204G, 204G1, 204G2, 204G3, 204G4, 204G5, 204G6) angrenzend an das erste Durchgangsloch (TV, TV-1, TV-2, TV-3, TV-4, TV-5, TV-6, TV-4A, TV-5A, TV-6A, TV-7A, TV-8A, TV-9A, TV-10A, TV-11A, TV-12A) freizulegen.

2. Elektronisches System (500) nach Anspruch 1, wobei die erste Masseebene (204G, 204G1, 204G2, 204G3, 204G4, 204G5, 204G6, 206G, 206G1, 206G2, 206G3, 206G4, 206G5, 206G6) auf einer oberen Oberfläche (202t) der Aufbauschichtstruktur (202) angeordnet ist und sich in der Vorrichtungs-Befestigungsregion (200CR) befindet; und
wobei das erste Durchgangsloch (TV, TV-1, TV-2, TV-3, TV-4, TV-5, TV-6, TV-4A, TV-5A, TV-6A, TV-7A, TV-8A, TV-9A, TV-10A, TV-11A, TV-12A) mit der ersten Masseebene (204G, 204G1, 204G2, 204G3, 204G4, 204G5, 204G6) gekoppelt ist.

3. Elektronisches System (500) nach Anspruch 2, wobei die Halbleitervorrichtung (300) durch eine Vielzahl von leitenden Strukturen (322, 322G1, 322G2, 322G3, 322G4, 322G5, 322P1, 322P2, 322P3, 322S1, 322S2, 322S3) auf der Vorrichtungs-Befestigungsregion (200CR) der Basis (200) montiert ist und wobei die Vielzahl von leitenden Strukturen (322, 322G1, 322G2, 322G3, 322G4, 322G5, 322P1, 322P2, 322P3, 322S1, 322S2, 322S3) mindestens eine geerdete leitende Struktur (322, 322G1, 322G2, 322G3, 322G4, 322G5) umfasst, die in Kontakt mit dem Massepolster (224G, 224G1, 224G2, 224G3, 224G4, 224G5) angeordnet ist, und wobei das Massepolster (224G, 224G1, 224G2, 224G3, 224G4, 224G5) in Kontakt mit der vertikalen Verbindungsstruktur (HDI, HDI-2, HDI-3, HDI-4, HDI-5, HDI-6, HDI-7, HDI-8, HDI-9, HDI-10, HDI-11) entsprechend der leitenden Struktur (322, 322G1, 322G2, 322G3, 322G4, 322G5) der Halbleitervorrichtung (300) angeordnet ist.

4. Elektronisches System (500) nach Anspruch 3, wobei das Massepolster (224G, 224G1, 224G2, 224G3, 224G4, 224G5) von dem ersten Durchgangsloch (TV, TV-1, TV-2, TV-3, TV-4, TV-5, TV-6, TV-4A, TV-5A, TV-6A, TV-7A, TV-8A, TV-9A, TV-10A, TV-11A, TV-12A) entlang einer ersten Richtung (100) versetzt ist, wobei die erste Richtung (100) im Wesentlichen parallel zu der oberen Oberfläche (200t) der Basis (200) verläuft.

5. Elektronisches System (500) nach Anspruch 4, wobei das Massepolster (224G, 224G1, 224G2, 224G3, 224G4, 224G5) und ein Abschnitt der ersten Masseebene (204G, 204G1, 204G2, 204G3, 204G4, 204G5, 204G6) angrenzend an das Massepolster (224G, 224G1, 224G2, 224G3, 224G4, 224G5) von der ersten Öffnung (230, 230-1, 230-2, 230-3, 230-4A, 230-4B, 230-5B, 230-6B, 230-8B, 230-9B, 230-10B, 230-10C, 230-11B, 230-12B) freigelegt werden.

6. Elektronisches System (500) nach Anspruch 1, wobei die mindestens eine geerdete leitende Struktur (322, 322G1, 322G2, 322G3, 322G4, 322G5) angrenzend an das erste Durchgangsloch (TV, TV-1, TV-2, TV-3, TV-4, TV-5, TV-6, TV-4A, TV-5A, TV-6A, TV-7A, TV-8A, TV-9A, TV-10A, TV-11A, TV-12A) durch die erste Öffnung (230, 230-1, 230-2, 230-3, 230-4A, 230-4B, 230-5B, 230-6B, 230-8B, 230-9B, 230-10B, 230-10C, 230-11B, 230-12B) freigelegt ist.

7. Elektronenstruktur nach Anspruch 1, wobei die Basis (200) ferner Folgendes umfasst:
eine zweite leitende Schicht (206), die auf einer unteren Oberfläche (202B) der Aufbauschichtstruktur (202) angeordnet ist, wobei die zweite leitende Schicht (206) eine zweite Masseebene (206G, 206G1, 206G2, 206G3, 206G4, 206G5, 206G6) in Kontakt mit dem ersten Durchgangsloch (TV-1, TV-2, TV-3, TV-4, TV-5, TV-6, TV-4A, TV-5A, TV-6A, TV-7A, TV-8A, TV-9A, TV-10A, TV-11A, TV-12A) umfasst; und
eine zweite Lötmaskenschicht (210), die auf der zweiten leitenden Schicht (206) angeordnet ist;
wobei die zweite Lötmaskenschicht (210) eine zweite Öffnung (240, 240-1, 240-2, 240-3, 240-4, 240-4B, 240-5, 240-5B, 240-6B, 240-8B, 240-9B, 240-10B, 240-10C, 240-11B, 240-12B) aufweist, um das erste Durchgangsloch (TV-1, TV-2, TV-3, TV-4, TV-5, TV-6, TV-4A, TV-5A, TV-6A, TV-7A, TV-8A, TV-9A, TV-10A, TV-11A, TV-12A) freizulegen.

8. Elektronisches System (500) nach Anspruch 1, wobei
die erste leitende Schicht (204) Basispolster (224, 224G, 224P, 224S, 224G1, 224G2, 224G3, 224G4, 224G5, 224P1, 224P2, 224P3, 224S1, 224S2, 224S3) umfasst, die das Massepolster (224G, 224G1, 224G2, 224G3, 224G4, 224G5) umfassen,
jedes der Basispads (224, 224G, 224P, 224S, 224G1, 224G2, 224G3, 224G4, 224G5, 224P1, 224P2, 224P3, 224S1, 224S2, 224S3) eine Polsterform (224) und einen Padbereich (A1) aufweist und
das erste Durchgangsloch (TV, TV-1, TV-2, TV-3, TV-4, TV-5, TV-6, TV-4A, TV-5A, TV-6A, TV-7A, TV-8A, TV-9A, TV-10A, TV-11A, TV-12A) zwischen den Polstern (224, 224G, 224P, 224S, 224G1, 224G2, 224G3, 224G4, 224G5, 224P1, 224P2, 224P3, 224S1, 224S2, 224S3) zwischengeschaltet ist und eine erste Durchgangslochform und einen ersten Durchgangslochbereich (A4, A5, A6, A7, A8, A9, A10, A11, A12) aufweist.

9. Elektronisches System (500) nach Anspruch 8, wobei das erste Durchgangsloch (TV, TV-1, TV-2, TV-3, TV-4, TV-5, TV-6, TV-5A, TV-7A, TV-9A, TV-10A, TV-11A, TV-12A) die gleiche Form wie die Polsterform(224) aufweist und wobei der erste Durchgangslochbereich (A4, A5, A6, A7, A8, A9, A10, A11, A12) größer oder gleich dem Polsterbereich (A1) ist.

10. Elektronisches System (500) nach Anspruch 8, wobei die Durchgangsform (TV, TV-1, TV-2, TV-3, TV-4, TV-5, TV-6, TV-4A, TV-5A, TV-6A, TV-7A, TV-8A, TV-9A, TV-10A, TV-11A, TV-12A) einen Kreis, ein Oval, ein Kreuzzeichen, den Buchstaben X, eine Linienform oder eine Kombination davon umfasst.

11. Elektronisches System (500) nach Anspruch 1, wobei die Aufbauschichtstruktur (202) ferner Folgendes umfasst:
ein zweites Durchgangsloch (TV, TV-1, TV-2, TV-3, TV-4, TV-5, TV-6, TV-5A, TV-6A, TV-7A, TV-9A, TV-10A, TV-12A), das durch die Aufbauschichtstruktur (202) verläuft und sich in der Vorrichtungs-Befestigungsregion (200CR) befindet, wobei das zweite Durchgangsloch (TV, TV-1, TV-2, TV-3, TV-4, TV-5, TV-6, TV-5A, TV-6A, TV-7A, TV-9A, TV-10A, TV-12A) einen zweiten Durchgangslochbereich (A5, A6, A7, A9, A10, A12) und eine zweite Durchgangslochform aufweist.

12. Elektronisches System (500) nach Anspruch 10, wobei die erste Lötmaskenschicht (208, 210) eine dritte Öffnung (230-6B, 230-10B, 240-6B, 240-10B, 230-10C) umfasst, um das zweite Durchgangsloch (TV-6A, TV-10A) freizulegen, wobei eine erste Form der ersten Öffnung (230-6B, 230-10B, 240-6B, 240-10B) der Form des ersten Durchgangslochs (TV-6A, TV-10A) entspricht und eine zweite Form der dritten Öffnung (230-6B, 230-10B, 240-6B, 240-10B) der Form des zweiten Durchgangslochs (TV-6A, TV-10A) entspricht.

13. Elektronisches System (500) nach Anspruch 8, wobei sich die Form des ersten Durchgangslochs (TV-4A, TV-6A, TV-8A) von der Polsterform(224) unterscheidet.

14. Elektronisches System (500) nach Anspruch 12, wobei ein Bereich (B4, B6, B8) der ersten Öffnung (230-4B, 230-6B, 230-8B, 240-4B, 240-6B, 240-8B) größer als das Doppelte eines Bereichs des Polsters (224) ist; oder
wobei die Form der ersten Öffnung (230-4B, 230-6B, 230-8B, 240-4B, 240-6B, 240-8B) die gleiche Form wie die Form des ersten Durchgangslochs (TV-4A, TV-6A, TV-8A) aufweist.

15. Elektronisches System (500) nach Anspruch 1, wobei die Halbleitervorrichtung (300) auf der Vorrichtungs-Befestigungsregion (200CR) der Basis (200) durch die mindestens eine geerdete leitende Struktur (322, 322G1, 322G2, 322G3, 322G4, 322G5), die mit dem ersten Durchgangsloch (TV-1, TV-2, TV-3, TV-4, TV-5, TV-6, TV-4A, TV-5A, TV-6A, TV-7A, TV-8A, TV-9A, TV-10A, TV-11A, TV-12A) verbunden ist, montiert ist und wobei die mindestens eine geerdete leitende Struktur (322, 322G1, 322G2, 322G3, 322G4, 322G5) direkt über der vertikalen Verbindungsstruktur (HDI, HDI-2, HDI-3, HDI-4, HDI-5, HDI-6, HDI-7, HDI-8, HDI-9, HDI-10, HDI-11) und nicht über dem ersten Durchgangsloch (TV-1, TV-2, TV-3, TV-4, TV-5, TV-6, TV-4A, TV-5A, TV-6A, TV-7A, TV-8A, TV-9A, TV-10A, TV-11A, TV-12A) angeordnet ist.

## Revendications

1. Système électronique (500), comprenant :
une base (200) ayant une région de fixation de dispositif (200CR), dans lequel la base (200) comprend :
une structure de couches empilées (202) ;
une structure d'interconnexion verticale (HDI, HDI-2, HDI-3, HDI-4, HDI-5, HDI-6, HDI-7, HDI-8, HDI-9, HDI-10, HDI-11) traversant la structure de couches empilées (202) et située dans la région de fixation de dispositif (200CR), dans lequel la structure d'interconnexion verticale (HDI, HDI-2, HDI-3, HDI-4, HDI-5, HDI-6, HDI-7, HDI-8, HDI-9, HDI-10, HDI-11) comprend au moins un via enterré (212) et au moins un via borgne (214) couplé électriquement au via enterré (212) ; et
un premier via traversant (TV, TV-1, TV-2, TV-3, TV-4, TV-5, TV-6, TV-4A, TV-5A, TV-6A, TV-7A, TV-8A, TV-9A, TV-10A, TV-11A, TV-12A) traversant la structure de couches empilées (202) et situé dans la région de fixation de dispositif (200CR), dans lequel le premier via traversant (TV, TV-1, TV-2, TV-3, TV-4, TV-5, TV-6, TV-4A, TV-5A, TV-6A, TV-7A, TV-8A, TV-9A, TV-10A, TV-11A, TV-12A) est un via traversant droit (TV, TV-1, TV-2, TV-3, TV-4, TV-5, TV-6, TV-4A, TV-5A, TV-6A, TV-7A, TV-8A, TV-9A, TV-10A, TV-11A, TV-12A) ; et
un dispositif semi-conducteur (300) monté sur la région de fixation de dispositif (200CR) de la base (200).
dans lequel la base (200) comprend également une première couche conductrice (204) disposée sur la surface supérieure (202t) de la structure de couches empilées (202), et une première couche de masque de soudure (208) disposée sur la première couche conductrice (204), dans lequel la première couche conductrice (204) comprend un premier plan de masse (204G, 204G1, 204G2, 204G3, 204G4, 204G5, 204G6) comprenant au moins un plot de masse (224G, 224G1, 224G2, 224G3, 224G4, 224G5) dans la région de fixation de dispositif (200CR), et
dans lequel la première couche de masque de soudure (208) a une première ouverture (230, 230-1, 230-2, 230-3, 230-4A, 230-4B, 230-5B, 230-6B, 230-8B, 230-9B, 230-10B, 230-10C, 230-11B, 230-12B) pour exposer le premier via traversant (TV-1, TV-2, TV-3, TV-4, TV-5, TV-6, TV-4A, TV-5A, TV-6A, TV-7A, TV-8A, TV-9A, TV-10A, TV-11A, TV-12A) et une partie du premier plan de masse (204G, 204G1, 204G2, 204G3, 204G4, 204G5, 204G6) adjacente au premier via traversant (TV, TV-1, TV-2, TV-3, TV-4, TV-5, TV-6, TV-4A, TV-5A, TV-6A, TV-7A, TV-8A, TV-9A, TV-10A, TV-11A, TV-12A).

2. Système électronique (500) selon la revendication 1, dans lequel le premier plan de masse (204G, 204G1, 204G2, 204G3, 204G4, 204G5, 204G6, 206G, 206G1, 206G2, 206G3, 206G4, 206G5, 206G6) est disposé sur une surface supérieure (202t) de la structure de couches empilées (202) et situé dans la région de fixation de dispositif (200CR) ; et
dans lequel le premier via traversant (TV, TV-1, TV-2, TV-3, TV-4, TV-5, TV-6, TV-4A, TV-5A, TV-6A, TV-7A, TV-8A, TV-9A, TV-10A, TV-11A, TV-12A) est couplé au premier plan de masse (204G, 204G1, 204G2, 204G3, 204G4, 204G5, 204G6).

3. Système électronique (500) selon la revendication 2, dans lequel le dispositif semi-conducteur (300) est monté sur la région de fixation de dispositif (200CR) de la base (200) par une pluralité de structures conductrices (322, 322G1, 322G2, 322G3, 322G4, 322G5, 322P1, 322P2, 322P3, 322S1, 322S2, 322S3), et
dans lequel la pluralité de structures conductrices (322, 322G1, 322G2, 322G3, 322G4, 322G5, 322P1, 322P2, 322P3, 322S1, 322S2, 322S3) comprend au moins une structure conductrice mise à la terre (322, 322G1, 322G2, 322G3, 322G4, 322G5) disposée en contact avec le plot de masse (224G, 224G1, 224G2, 224G3, 224G4, 224G5), et dans lequel le plot de masse (224G, 224G1, 224G2, 224G3, 224G4, 224G5) est disposé en contact avec la structure d'interconnexion verticale (HDI, HDI-2, HDI-3, HDI-4, HDI-5, HDI-6, HDI-7, HDI-8, HDI-9, HDI-10, HDI-11) correspondant à la structure conductrice (322, 322G1, 322G2, 322G3, 322G4, 322G5) du dispositif semi-conducteur (300).

4. Système électronique (500) selon la revendication 3, dans lequel le plot de masse (224G, 224G1, 224G2, 224G3, 224G4, 224G5) est décalé par rapport au premier via traversant (TV, TV-1, TV-2, TV-3, TV-4, TV-5, TV-6, TV-4A, TV-5A, TV-6A, TV-7A, TV-8A, TV-9A, TV-10A, TV-11A, TV-12A) le long d'une première direction (100), dans lequel la première direction (100) est sensiblement parallèle à la surface supérieure (200t) de la base (200).

5. Système électronique (500) selon la revendication 4, dans lequel le plot de masse (224G, 224G1, 224G2, 224G3, 224G4, 224G5) et une partie du premier plan de masse (204G, 204G1, 204G2, 204G3, 204G4, 204G5, 204G6) adjacente au plot de masse (224G, 224G1, 224G2, 224G3, 224G4, 224G5) sont exposés à partir de la première ouverture (230, 230-1, 230-2, 230-3, 230-4A, 230-4B, 230-5B, 230-6B, 230-8B, 230-9B, 230-10B, 230-10C, 230-11B, 230-12B).

6. Système électronique (500) selon la revendication 1, dans lequel l'au moins une structure conductrice mise à la terre (322, 322G1, 322G2, 322G3, 322G4, 322G5) adjacente au premier via traversant (TV, TV-1, TV-2, TV-3, TV-4, TV-5, TV-6, TV-4A, TV-5A, TV-6A, TV-7A, TV-8A, TV-9A, TV-10A, TV-11A, TV-12A) est exposée par la première ouverture (230, 230-1, 230-2, 230-3, 230-4A, 230-4B, 230-5B, 230-6B, 230-8B, 230-9B, 230-10B, 230-10C, 230-11B, 230-12B).

7. Structure électronique selon la revendication 1, dans laquelle la base (200) comprend également :
une seconde couche conductrice (206) disposée sur une surface inférieure (202B) de la structure de couches empilées (202), dans laquelle la seconde couche conductrice (206) comprend un second plan de masse (206G, 206G1, 206G2, 206G3, 206G4, 206G5, 206G6) en contact avec le premier via traversant (TV-1, TV-2, TV-3, TV-4, TV-5, TV-6, TV-4A, TV-5A, TV-6A, TV-7A, TV-8A, TV-9A, TV-10A, TV-11A, TV-12A) ; et
une seconde couche de masque de soudure (210) disposée sur la seconde couche conductrice (206) ;
dans lequel la seconde couche de masque de soudure (210) a une deuxième ouverture (240, 240-1, 240-2, 240-3, 240-4, 240-4B, 240-5, 240-5B, 240-6B, 240-8B, 240-9B, 240-10B, 240-10C, 240-11B, 240-12B) pour exposer le premier via traversant (TV-1, TV-2, TV-3, TV-4, TV-5, TV-6, TV-4A, TV-5A, TV-6A, TV-7A, TV-8A, TV-9A, TV-10A, TV-11A, TV-12A).

8. Système électronique (500) selon la revendication 1, dans lequel
la première couche conductrice (204) comprend des plots de base (224, 224G, 224P, 224S, 224G1, 224G2, 224G3, 224G4, 224G5, 224P1, 224P2, 224P3, 224S1, 224S2, 224S3) comprenant le plot de masse (224G, 224G1, 224G2, 224G3, 224G4, 224G5),
chacun des plots de base (224, 224G, 224P, 224S, 224G1, 224G2, 224G3, 224G4, 224G5, 224P1, 224P2, 224P3, 224S1, 224S2, 224S3) a une forme de plot (224) et une surface de plot (A1), et
le premier via traversant (TV, TV-1, TV-2, TV-3, TV-4, TV-5, TV-6, TV-4A, TV-5A, TV-6A, TV-7A, TV-8A, TV-9A, TV-10A, TV-11A, TV-12A) est interposé entre les plots (224, 224G, 224P, 224S, 224G1, 224G2, 224G3, 224G4, 224G5, 224P1, 224P2, 224P3, 224S1, 224S2, 224S3) et a une forme de premier via traversant et une surface de premier via traversant (A4, A5, A6, A7, A8, A9, A10, A11, A12).

9. Système électronique (500) selon la revendication 8, dans lequel la forme de premier via traversant (TV, TV-1, TV-2, TV-3, TV-4, TV-5, TV-6, TV-5A, TV-7A, TV-9A, TV-10A, TV-11A, TV-12A) est identique à la forme du plot (224), et dans lequel la surface de premier via traversant (A4, A5, A6, A7, A8, A9, A10, A11, A12) est supérieure ou identique à la surface de plot (A1).

10. Système électronique (500) selon la revendication 8, dans lequel la forme de via traversant (TV, TV-1, TV-2, TV-3, TV-4, TV-5, TV-6, TV-4A, TV-5A, TV-6A, TV-7A, TV-8A, TV-9A, TV-10A, TV-11A, TV-12A) comprend un cercle, un ovale, un signe croisé, la lettre X, une forme de ligne ou une combinaison de ceux-ci.

11. Système électronique (500) selon la revendication 1, dans lequel la structure de couches empilées (202) comprend également :
un second via traversant (TV, TV-1, TV-2, TV-3, TV-4, TV-5, TV-6, TV-5A, TV-6A, TV-7A, TV-9A, TV-10A, TV-12A) traversant la structure de couches empilées (202) et situé dans la région de fixation de dispositif (200CR), dans lequel le second via traversant (TV, TV-1, TV-2, TV-3, TV-4, TV-5, TV-6, TV-5A, TV-6A, TV-7A, TV-9A, TV-10A, TV-12A) a une surface de second via traversant (A5, A6, A7, A9, A10, A12) et une forme de second via traversant.

12. Système électronique (500) selon la revendication 10, dans lequel la première couche de masque de soudure (208, 210) comprend une troisième ouverture (230-6B, 230-10B, 240-6B, 240-10B, 230-10C) pour exposer le second via traversant (TV-6A, TV-10A), dans lequel une première forme de la première ouverture (230-6B, 230-10B, 240-6B, 240-10B) correspond à la forme de premier via traversant (TV-6A, TV-10A), et une seconde forme de la troisième ouverture (230-6B, 230-10B, 240-6B, 240-10B) correspond à la forme de second via traversant (TV-6A, TV-10A).

13. Système électronique (500) selon la revendication 8, dans lequel la forme du premier via traversant (TV-4A, TV-6A, TV-8A) est différente de la forme du plot (224).

14. Système électronique (500) selon la revendication 12, dans lequel une surface (B4, B6, B8) de la première ouverture (230-4B, 230-6B, 230-8B, 240-4B, 240-6B, 240-8B) est supérieure à deux fois une surface du plot (224) ; ou
dans lequel la forme de la première ouverture (230-4B, 230-6B, 230-8B, 240-4B, 240-6B, 240-8B) est la même que la forme du premier via traversant (TV-4A, TV-6A, TV-8A).

15. Système électronique (500) selon la revendication 1, dans lequel le dispositif semi-conducteur (300) est monté sur la région de fixation de dispositif (200CR) de la base (200) par l'au moins une structure conductrice mise à la terre (322, 322G1, 322G2, 322G3, 322G4, 322G5) se connectant au premier via traversant (TV-1, TV-2, TV-3, TV-4, TV-5, TV-6, TV-4A, TV-5A, TV-6A, TV-7A, TV-8A, TV-9A, TV-10A, TV-11A, TV-12A), et dans lequel l'au moins une structure conductrice mise à la terre (322, 322G1, 322G2, 322G3, 322G4, 322G5) est disposée directement au-dessus de la structure d'interconnexion verticale (HDI, HDI-2, HDI-3, HDI-4, HDI-5, HDI-6, HDI-7, HDI-8, HDI-9, HDI-10, HDI-11) plutôt qu'au-dessus du premier via (TV-1, TV-2, TV-3, TV-4, TV-5, TV-6, TV-4A, TV-5A, TV-6A, TV-7A, TV-8A, TV-9A, TV-10A, TV-11A, TV-12A).
